(19) Europäisches Patentamt
European Patent Office
Office européen des brevets

(11) **EP 2 088 131 A1**

(12) **EUROPEAN PATENT APPLICATION**
published in accordance with Art. 153(4) EPC

(43) Date of publication:
**12.08.2009 Bulletin 2009/33**

(51) Int Cl.:
*C03C 17/09* (2006.01)   *A01N 25/08* (2006.01)
*A01N 59/16* (2006.01)   *A01N 59/20* (2006.01)
*A01P 3/00* (2006.01)   *B01J 35/02* (2006.01)
*B32B 15/04* (2006.01)   *B32B 17/06* (2006.01)
*C03C 17/36* (2006.01)   *C23C 14/34* (2006.01)

(21) Application number: **07829936.9**

(86) International application number:
**PCT/JP2007/070202**

(22) Date of filing: **16.10.2007**

(87) International publication number:
**WO 2008/047810 (24.04.2008 Gazette 2008/17)**

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **16.10.2006   JP 2006280850
16.10.2006   JP 2006280865**

(71) Applicant: **Nippon Sheet Glass Company Limited
Tokyo 108-6321 (JP)**

(72) Inventors:
• **INAOKA, Daisuke
Minato-ku
Tokyo 108-6321 (JP)**
• **ANZAKI, Toshiaki
Minato-ku
Tokyo 108-6321 (JP)**

(74) Representative: **Hart-Davis, Jason et al
Cabinet Beau de Loménie,
158, rue de l'Université
75340 Paris Cedex 07 (FR)**

(54) **ANTIBACTERIAL SUBSTRATUM AND PROCESS FOR PRODUCING THE SAME**

(57) An antibacterial substrate of the present invention includes a substrate and a plurality of antibacterial metal islands formed on the surface of the substrate. The antibacterial metal islands are exposed to an external atmosphere. The average value of contact angles between the substrate and the respective antibacterial metal islands is 90 degrees or less, as measured on the basis of results of surface observation with a scanning electron microscope.

FIG. 1

EP 2 088 131 A1

**Description**

**Technical Field**

The present invention relates to an antibacterial substrate and a method of manufacturing the same.

**Background Art**

In recent years, inorganic antibacterial agents have attracted attention because they are superior in safety and durability to organic antibacterial agents. Examples of such inorganic antibacterial agents include those employing antibacterial metals such as silver, copper, and zinc having an antibacterial effect and those employing photocatalysts such as titanium oxide.

Antibacterial metals such as silver, copper, and zinc deactivate bacteria by a substitution reaction with component materials of cell membranes and cytoplasms and thus exert an antibacterial effect. On the other hand, photocatalysts such as titanium oxide produce reactive oxygen species when irradiated with ultraviolet rays. These reactive oxygen species attack cell walls and membranes of bacteria, and thus the photocatalysts exert an antibacterial effect.

There is also a known technique of using a photocatalyst and an antibacterial metal in combination so that the photocatalyst destroys the cell walls of bacteria and the like and the antibacterial metal promotes its antibacterial function.

JP 2004-183030 A discloses "a foil or a film having an antibacterial function **characterized in that** a coating film layer such as a plated layer or a metal thin film layer formed of an antibacterial metal is formed on the surface of a substrate of the foil or the film." JP 2004-183030 A also discloses that the antibacterial metal is silver.

JP 09(1997)-111380 A discloses "an Ag-Cu-Zn alloy excellent in antibacterial and antifungal properties having a composition consisting of 20 to 60 atomic % of Ag, 20 to 60 atomic % of Cu, and 20 to 60 atomic % of Zn." An alloy coating film is formed by a sputtering method using this alloy as a target.

JP 2006-152353 A discloses "an Ag-Cu alloy antibacterial thin film containing Cu as an essential component." JP 2006-152353 A also discloses that the Ag-Cu alloy antibacterial thin film is formed by a sputtering method using the Ag-Cu alloy as a target.

JP 2000-246115 A discloses an invention of "a photocatalytically functional member in which a substance exhibiting a photocatalytic function or a material including the substance is deposited, at least on an exposed surface of a substrate, in a discontinuous manner such that the substance or the material is dispersed substantially uniformly with an average intermolecular spacing of 1 mm or less." JP 2000-246115 A discloses a use of a semiconductor or semiconductor fine particles having a photocatalytic function as such a substance exhibiting a photocatalytic function.

WO 2006/064059 A1 discloses a process for producing a substrate having an antibacterial property, in which a metal non-gelling layer including an inorganic antibacterial agent obtained from a precursor in metal, colloid, chelate or ion form is formed and subjected to thermal treatment to diffuse the antibacterial agent.

The antibacterial metal diffused in the substrate does not contribute substantially to the antibacterial effect. Therefore, the substrate described in WO 2006/064059 A1 cannot exert the antibacterial effect efficiently in spite of an adequate abundance of the antibacterial metal, and thus it is economically wasteful. In addition, the antibacterial metal tends to cause changes in the appearance of the substrate such as discoloration thereof. Therefore, the amount of antibacterial metal to be deposited on the substrate should be controlled strictly.

One example of a method for depositing a small amount of antibacterial metal on a substrate is a method of spraying a dispersion liquid including antibacterial metal particles on a nanometer scale onto the surface of the substrate. However, since the antibacterial metal particles deposited on the substrate by this method have an approximately spherical shape, they have poor adhesion to the substrate. Accordingly, this method has a problem that the antibacterial metal particles fall off easily from the substrate and thus their antibacterial properties are not maintained.

**Disclosure of the Invention**

The present invention has been devised in view of the conventional problems described above, and it is an object of the present invention to provide an antibacterial substrate not only exhibiting an antibacterial property sufficiently and persistently but also being economically excellent.

The present invention provides an antibacterial substrate including a substrate and a plurality of antibacterial metal islands formed on a surface of the substrate. In this antibacterial substrate, the antibacterial metal islands are exposed to an external atmosphere, and an average value of contact angles between the substrate and the respective antibacterial metal islands is 90 degrees or less, as measured on the basis of results of surface observation with a scanning electron microscope.

In another aspect, the present invention provides a method of manufacturing an antibacterial substrate including: a step of depositing an antibacterial metal in a form of islands, with a target film thickness of at least 0.1 nm but not more than 3 nm, on a surface of a substrate by a sputtering method carried out in an atmosphere of a gas containing an inert gas as a main component.

During a thin film formation process of a sputtering method, nucleation occurs first and subsequently continuous film formation proceeds. In the present invention, however, sputtering is stopped before continuous film formation starts, on purpose. As a result, antibacterial metal islands are formed on the surface of the substrate in such a manner that an average value of contact angles is 90 degrees or less, as measured on the basis of results of observation with a scanning electron microscope.

According to the antibacterial substrate of the present invention, since an appropriate amount of antibacterial metal is present on the surface of the substrate, it exerts an excellent antibacterial effect. In addition, since an average of contact angles between the substrate and the antibacterial metal islands is as small as 90 degrees or less, the antibacterial metal islands have good adhesion to the substrate and thus their antibacterial effect is maintained for a long period of time. Furthermore, an amount of antibacterial metal to be deposited on the substrate is controlled strictly. Therefore, if the substrate has a light transmitting property, the light transmitting property is not impaired. Such a substrate also is economically excellent.

It should be noted that in the present description, the phrase "a form of islands" means a state in which small islands are scattered in a discrete manner. In other words, the phrase "a plurality of antibacterial metal islands formed on a surface of a substrate" means a group of antibacterial metal bodies (antibacterial islands) deposited on the surface of the substrate in a scattered manner.

The term "a contact angle" means an angle formed between the surface of the substrate and a tangent at a contact point between the substrate and each antibacterial metal island. Assuming that the surface of the substrate is flat, an apparent contact angle of an antibacterial metal island is determined as a real contact angle thereof. The phrase "an average value of contact angles is 90 degrees or less" means that a value obtained by averaging contact angles of two or more antibacterial metal islands, specifically 10 arbitrarily selected islands in the case where the contact angles should be measured strictly, is 90 degrees or less. The contact angles are measured on the basis of results of surface observation of the antibacterial substrate with a scanning electron microscope.

Since antibacterial metals are oxidized as time passes, antibacterial metal islands often include metal oxides. In the present description, however, oxides of antibacterial metals also are regarded as antibacterial metals and are not distinguished therefrom.

**Brief Description of the Drawings**

FIG. 1 is a cross sectional view showing one example of a typical structure of an antibacterial substrate of the present invention.
FIG. 2 is a cross sectional view showing another example of a typical structure of an antibacterial substrate of the present invention.
FIG. 3 is a cross sectional view showing still another example of a typical structure of an antibacterial substrate of the present invention.
FIG. 4 is a cross sectional view showing further still another example of a typical structure of an antibacterial substrate of the present invention.
FIG. 5 is a schematic view showing a method for forming antibacterial metal islands on a surface of a substrate.
FIG. 6 is a cross-sectional SEM image of an antibacterial substrate of Example 1.
FIG. 7 is a reflection electron image showing a surface of a antibacterial substrate of Example 14.
FIG. 8 is a cross-sectional SEM image of Comparative Example 9.
FIG. 9 is a secondary electron image showing a surface of Comparative Example 9.
FIG. 10 is a cross-sectional SEM image of an antibacterial substrate of Example 20.
FIG. 11 is a reflection electron image showing a surface of the antibacterial substrate of Example 20.
FIG. 12 is a cross-sectional SEM image of an antibacterial substrate of Example 22.
FIG. 13 is a reflection electron image showing a surface of the antibacterial substrate of Example 22.
FIG. 14 is a cross-sectional SEM image of Comparative Example 16.
FIG. 15 is a secondary electron image showing a surface of Comparative Example 16.

**Best Mode for Carrying out the Invention**

Hereinafter, an embodiment of the antibacterial substrate of the present invention will be described.
First, antibacterial metal islands formed on a surface of a substrate will be described.
The antibacterial metal islands can be formed so that an average value of the diameters thereof is in a range of 5 to 500 nm. This feature allows the antibacterial metal islands to have a larger specific surface area, and as a result, makes it possible to provide an antibacterial substrate that can exert an antibacterial effect effectively.

The average value of the diameters of the antibacterial metal islands may be in a range of 5 to 50 nm. This feature makes it possible to provide an antibacterial substrate excellent in abrasion resistance.

It should be noted that the average value of the diameters of the antibacterial metal islands means the average value of the diameters of circular contact surfaces between the antibacterial metal islands and the substrate. In the case where the contact surfaces are not circular, the average value of the diameters of circles having the same areas as those of the contact surfaces may be used.

At least one antibacterial metal island may be present in an arbitrary region having an area of 1 $\mu$m $\times$ 1 $\mu$m on the surface of the substrate. This feature allows the substrate to exert an antibacterial effect uniformly across the surface.

The amount of antibacterial metal to be deposited on the substrate should be controlled strictly in order to prevent changes in the appearance of the substrate as much as possible and to improve the economy. In the case where the substrate has a light transmitting property, a difference $\Delta$T between the visible light transmittance of the antibacterial substrate and the visible light transmittance of the substrate without the antibacterial metal islands may be 15% or less.

How to remove the antibacterial metal islands when the difference $\Delta$T between the visible light transmittance of the antibacterial substrate and the visible light transmittance of the substrate without the antibacterial metal islands is measured will be described below. The antibacterial metal deposited on the surface of the substrate can be removed by a method of etching selectively the antibacterial metal with a suitable etchant, or a method of abrading the surface of the antibacterial substrate. A part of the surface of the substrate may be abraded slightly together with the antibacterial metal, but such abrasion of the surface has a minor influence on the visible light transmittance and thus is negligible.

In the case where the substrate has a light transmitting property, the visible light transmittance of the antibacterial substrate may be 30% or more.

The maximum height of the antibacterial metal islands may be 50 nm or less. This feature makes a substance such as a dust cloth less likely to be snagged on the antibacterial metal islands. As a result, an antibacterial substrate having a high abrasion resistance can be provided. The lower limit of the maximum height of the antibacterial metal islands is not particularly limited, but an antibacterial metal island that can exert a high antibacterial effect has a height of 1 nm or more, for example.

The antibacterial metal islands may contain, as a main component metal, any one selected from the group consisting of silver, copper, and zinc. This feature makes it possible to provide an antibacterial substrate having an excellent antibacterial effect of silver, copper and zinc. In the present description, "a main component" means a component having the largest content by mass%. The antibacterial metal islands may be made substantially of a main component metal. It should be noted that the word "substantially" is not intended to exclude an inevitable inclusion of impurities.

The antibacterial metal island may include a main component metal and a smaller amount (by mass%) of an additive metal than that of the main component metal. This feature makes it possible to provide an antibacterial substrate including antibacterial metal islands having a high durability.

For example, in the case where silver is used as a main component metal of the antibacterial metal islands, palladium can be used suitably as an additive metal. This feature makes it possible to provide an antibacterial substrate that is excellent in corrosion resistance and abrasion resistance. In place of palladium or together with palladium, at least one selected from the group consisting of platinum, gold, iron, zinc, tin, and neodymium may be used as an additive metal.

An index, other than SEM images, indicating that an antibacterial metal is deposited in the form of islands is the surface resistance of an antibacterial substrate. In the case where the substrate is insulative, it can be judged that the antibacterial metal does not form a complete film but is deposited in the form of islands when the surface resistance of the antibacterial substrate is, for example, $10^7$ $\Omega$/$\square$ (ohm per square) or more.

Next, the substrate will be described. There is no particular limitation on the substrate as long as it is desired to be provided with antibacterial properties. It is preferable that the substrate has a light transmitting property. Specifically, the substrate can be formed of one or more materials selected from the group consisting of a glass sheet, a plastic sheet, and a plastic film. Furthermore, the substrate may be formed of a mirror. Each of these materials may be used as the substrate without being subjected to any process. Each of these materials may be used as the substrate after a base film or a photocatalyst film is formed thereon.

The substrate further may have a photocatalyst layer containing titanium oxide. In this case, the photocatalyst layer can serve as the surface of the substrate.

The substrate may have, as a base layer of the photocatalyst layer, a film containing polycrystalline zirconium oxide having a monoclinic crystalline structure. In this case, the photocatalyst layer may contain polycrystalline titanium oxide having an anatase crystalline structure. The lattice constant of zirconium oxide having a monoclinic crystalline structure is close to that of anatase-type titanium oxide. Therefore, a titanium oxide film can be grown heteroepitaxially by providing a base layer of zirconium oxide having a monoclinic crystalline structure. As a result, a photocatalyst layer having a high photocatalytic effect can be formed.

It also can be considered that the layer formed as described above is a photocatalyst layer including a zirconium oxide film as a part thereof.

The above-mentioned photocatalyst layer can be formed on the substrate by a known film-forming method, such as a chemical vapor deposition method, a sputtering method, and a liquid phase deposition method, prior to the formation of the antibacterial metal islands.

Among these methods, the sputtering method is recommended because a uniform film having a large area can be formed easily. In the case where the photocatalyst layer and antibacterial metal islands are formed by the sputtering method, a sputtering process for forming the photocatalyst layer and a sputtering process for forming the antibacterial metal islands can be carried out on the same manufacturing line. Therefore, an improvement in productivity can be expected.

In the case where a glass sheet produced by a float method is used as a body of the substrate (substrate main body), the photocatalyst layer containing titanium oxide may be formed by a thermal CVD method utilizing the temperature at the production of the glass. The thermal CVD method utilizing the temperature at the production of float glass generally is called an on-line CVD method (or in-bath CVD method). According to the on-line CVD method, a CVD apparatus for forming a photocatalyst layer is placed on a glass production line of the float method (in a float bath, for example). The glass production process by the float method and the photocatalyst layer formation process by the CVD method can be carried out in succession, which is economically excellent.

A metal may be added to the photocatalyst layer to the extent that the metal does not cause disorder in the crystalline structure. An addition of a small amount of metal promotes generation of charge carriers and thus enhances the photocatalytic activity. The content of the additive metal in the photocatalyst is suitably 0.001 mass% to 1.0 mass%. When the added amount of the metal is smaller than this suitable content thereof, the photocatalyst may not exhibit the charge carrier effect. When an excessively large amount of the metal is added, the crystalline structure may be disordered or recombination centers may be generated, which results in the reduction in the photocatalytic activity.

The substrate may include a substrate main body and a base layer formed in contact with the substrate main body. The base layer has a function of, for example, preventing diffusion of alkaline components contained in a glass sheet (substrate main body).

It is preferable that the base layer contains at least one selected from the group consisting of silicon oxide, silicon nitride, tin oxide, and zinc/tin complex oxide. The thickness of the base layer that is enough to obtain a sufficient effect is 5 to 10 nm. The base layer can be formed on the substrate main body by a known film-forming method such as a chemical vapor deposition method, a sputtering method, and a liquid phase deposition method, prior to the formation of the photocatalyst layer and the antibacterial islands.

Next, some examples of the typical structure of the antibacterial substrate will be described with reference to figures.

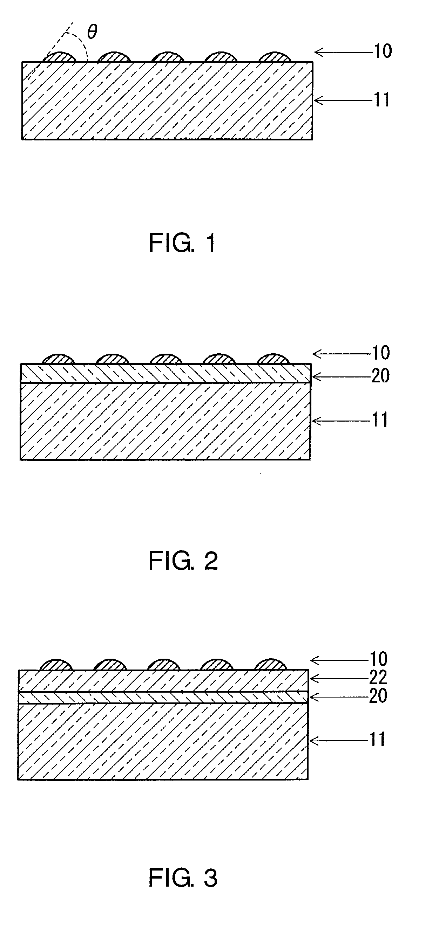

FIG. 1 is a cross sectional view showing one example of the typical structure of the antibacterial substrate of the present invention. In this example, a plurality of antibacterial metal islands 10 (a group of islands) are formed on the surface of a soda lime glass sheet 11 as a substrate having a light transmitting property. The antibacterial metal islands 10 are exposed to the external atmosphere. The color tone and light transmitting property inherent to the glass sheet 11 can be maintained in good condition by depositing the antibacterial metal thereon in the form of islands.

The average value of contact angles θ between the glass sheet 11 and the respective antibacterial metal islands 10 is 90 degrees or less. Since the contact angles θ are relatively small, the adhesion between the antibacterial metal islands 10 and the glass sheet 11 is good.

The contact angles θ are measured on the basis of the results of surface observation with a scanning electron microscope (SEM). The magnification of the SEM may be set to about 50,000 to 200,000 times. The magnification in this range allows the contact angles θ between the antibacterial metal islands 10 and the glass sheet 11 to be calculated easily and accurately.

As shown in FIG. 2, the antibacterial substrate may have a structure in which a silicon oxide film 20 as a base layer is formed on the surface of the soda lime glass sheet 11 (substrate main body) and the antibacterial metal islands 10 are formed on the surface of the silicon oxide film 20.

Furthermore, as shown in FIG. 3, the antibacterial substrate may have a structure in which an anatase-type titanium oxide film 22 as a photocatalyst layer is formed on the silicon oxide film 20 and the antibacterial metal islands 10 are formed on the surface of the titanium oxide film 22. When the antibacterial metal is deposited in the form of islands, the photo-oxidative degradation property of the titanium oxide film 22 hardly is impaired by the antibacterial metal.

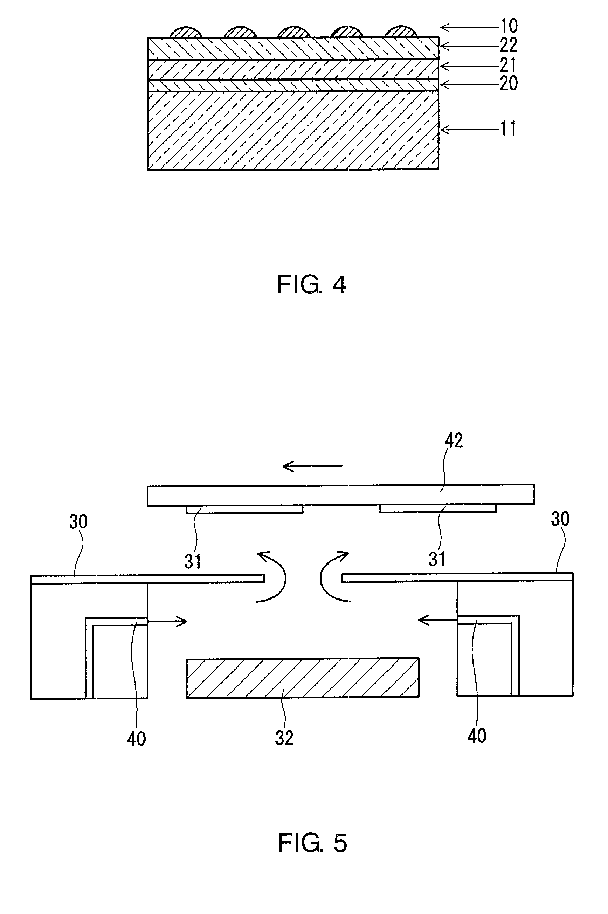

Furthermore, as shown in FIG. 4, a monoclinic zirconium oxide film 21 may be formed between the silicon oxide film 20 and the titanium oxide film 22.

Next, the manufacturing method of the antibacterial substrate will be described below.

The antibacterial substrate of the present invention can be manufactured by forming the antibacterial metal islands on the surface of the substrate by the sputtering method. The amount of the antibacterial metal to be deposited on the substrate by the sputtering method can be controlled strictly.

The sputtering method may be performed in an atmosphere of a gas containing an inert gas as a main component. The antibacterial metal may be deposited in the form of islands by the sputtering method, with a target film thickness of at least 0.1 nm but not more than 3 nm. Here, the "target film thickness" is a uniform thickness of a continuous film calculated on the assumption that a continuous film is made of the total amount of the antibacterial metal constituting the antibacterial metal islands. The target film thickness is not the actual height of each of the antibacterial metal islands.

This target film thickness can be provided by, for example, in the following manner. First, film forming conditions (such as a film forming apparatus, a film forming atmosphere gas, a degree of vacuum, substrate temperature, and a film forming power) are provided. A film forming process is carried out over a relatively long period of time under the above film forming conditions so as to form a continuous film made of the antibacterial metal on the substrate. The film forming process is repeated several times by changing only the film forming time so as to obtain continuous films having thicknesses different from each other. The thicknesses of the obtained continuous films are measured respectively so as to obtain the relationship between the film thickness and the film forming time. The thickness of the continuous film can be measured with a film thickness probe or an ellipsometer. An estimated film thickness to be formed during a predetermined film forming time can be obtained based on the relationship between the film thickness and the film forming time, and the estimated film thickness can be used as a target film thickness. That is, a film forming time corresponding to a predetermined target film thickness is calculated in advance, and the film forming time thus calculated is set as the film forming time of the antibacterial metal. According to this procedure, the antibacterial metal can be deposited in the form of islands.

The method for controlling strictly the amount of the antibacterial metal to be deposited is not limited to the above-mentioned method. Any other method can be applied without difficulty as long as the antibacterial metal can be deposited in the form of islands.

FIG. 5 is a schematic view showing a method for forming antibacterial metal islands on a surface of a substrate. As shown in FIG. 5, a plurality of substrates 31 are placed in a line on a carrier 42. The carrier 42 moves above a target 32 in the direction of the arrow.

Two shielding plates 30 are disposed between the carrier 42 and the target 30 in parallel to each other. The film growth rate can be controlled by adjusting the width of an open groove formed by the shielding plates 30. The width of the open groove may be adjusted in the range of, for example, 1 mm to 150 mm. The film growth rate also may be controlled by increasing the moving speed of the substrates 31 or reducing the input power, instead of or in addition to the adjustment of the width of the open groove. In the case where the sputtering conditions are changed, the width of the open groove may be adjusted taking into consideration of the target thickness of the film to be formed and the film forming efficiency.

Sputtering is carried out while providing a flow of an argon gas which is an inert gas through delivery pipes 40 in the direction of the straight arrows, that is, above the target 32. Antibacterial metal atoms released by sputtering pass through the open groove formed by the shielding plates 30 and deposit on the substrates 31.

The target 32 may be a metal containing an antibacterial metal such as silver, copper, and zinc as a main component metal. The target 32 may contain an appropriate amount of an additive metal in addition to the main component metal. For example, in the case where silver is used as a main component metal, the target 32 may contain, as an additive metal, at least one selected from the group consisting of platinum, gold, palladium, iron, zinc, tin, and neodymium. The addition of a small amount of a metal enhances the corrosion resistance of the antibacterial islands containing silver as a main component and suppresses the aggregation of silver. Among these additive metals, it is recommended to use palladium because of its excellent aggregation suppressing effect.

Furthermore, in the case where copper is used as a main component metal, the target 32 may contain, as an additive metal, at least one selected from the group consisting of tin, iron, zirconium, and chromium. By adding this additive metal, it can be expected that the corrosion resistance of the antibacterial metal islands containing copper as a main component is improved.

**EXAMPLES**

In order to describe the present invention in more detail, Examples and Comparative Examples are shown below. Firstly, samples having no photocatalyst layer are described. Secondly, samples each provided with a photocatalyst layer are described. Thirdly, samples using figured glass sheets are described.

(Examples 1 to 19 and Comparative Examples 1 to 9)

Tables 1-1 to 2-4 show the details of Examples and Comparative Examples. Tables 2-1 to 2-4 show the details of Examples 1 to 19, that is, the structures of respective layers, shapes of antibacterial metal islands, surface resistances, visible light transmittances, changes in visible light transmittance by the formation of antibacterial metal islands (differences in visible light transmittance between the case where antibacterial metal islands are present and the case where antibacterial metal islands are not present), antibacterial activity values in a dark place, and antibacterial activity values in a dark place after wiping with a damp cloth. Tables 1-1 and 1-2 show the same details of Comparative Examples 1 to 9 as those of Examples.

It should be noted that Comparative Example 8 is a commercially available antibacterial tile containing an antibacterial metal in the glaze. Comparative Example 9 is a sample obtained by spraying a commercially available alcohol dispersion liquid of Ag fine particles on the surface of a substrate and drying it at room temperature.

Table 1-1

| | | Comparative Example 1 | Comparative Example 2 | Comparative Example 3 | Comparative Example 4 | Comparative Example 5 |
|---|---|---|---|---|---|---|
| Substrate main body | Type | Soda lime glass | Soda lime glass | Soda lime glass | Soda lime glass | Soda lime glass |
| | Thickness | 3mm | 3mm | 3mm | 3mm | 3mm |
| Base layer | Silicon oxide film thickness | | 10nm | | | |
| Antibacterial metal islands | Antibacterial metal type | | | Cu | Ag | Ag+Pd (Pd:1.0 mass%) |
| | Target film thickness for antibacterial metal film formation | | | 10nm | 10nm | 10nm |
| | Average contact angle | | | Film | Film | Film |
| | Average diameter | | | Film | Film | Film |
| | Surface density | | | Film | Film | Film |
| | Average height | | | Film | Film | Film |
| Surface resistance | | >9.1×10$^7$ Ω/□ | >9.1×10$^7$ Ω/□ | 3.1 Ω/□ | 5.3×10$^6$ Ω/□ | 7.3×10$^6$ Ω/□ |
| Transmitted color tone | (a*,b*) | (-0.8, 0.4) | (-0.7, 0.6) | (1.6, 7.9) | (5.5, -7.2) | (5.0, -6.1) |
| | Color tone | Colorless | Colorless | Light yellow | Light purple | Light purple |
| Visible light transmittance | | 90.1% | 89.9% | 65.0% | 66.7% | 67.9% |
| Change in visible light transmittance by antibacterial metal | | - | - | -25.1% | -23.4% | -22.2% |
| Antibacterial property (ΔLog) | | × (ΔLOG = - 0.8) | × (ΔLOG = - 0.9) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | × (ΔLOG = - 0.8) | × (ΔLOG = - 0.9) | LEVEL 3 (ΔLOG > 4.0) | LEVEL 3 (ΔLOG > 4.0) | LEVEL 3 (ΔLOG > 4.0) |

## Table 1-2

| | | Comparative Example 6 | Comparative Example 7 | Comparative Example 8 | Comparative Example 9 |
|---|---|---|---|---|---|
| Substrate main body | Type | Soda lime glass | Soda lime glass | Tile | Soda lime glass |
| | Thickness | 3mm | 3mm | | 3mm |
| Base layer | Silicon oxide film thickness | | | | |
| Antibacterial metal islands | Antibacterial metal type | Ag+Pd (Pd:15 mass%) | Ag+Pd+Cu (Pd:0.9 mass% Cu:0.6 mass%) | Ag dispersion in glaze | Dispersion liquid of Ag fine particles is applied |
| | Target film thickness for antibacterial metal film formation | 10nm | 10nm | | |
| | Average contact angle | Film | Film | | 110° |
| | Average diameter | Film | Film | | 60nm |
| | Surface density | Film | Film | | 3 pieces／$\mu m^2$ |
| | Average height | Film | Film | | 50nm |
| Surface resistance | | $8.9 \times 10^6 \Omega/\square$ | $8.4 \times 10^6 \Omega/\square$ | | $> 9.1 \times 10^7 \Omega/\square$ |
| Transmitted color tone | (a*,b*) | (3.2 , -4.1) | (6.1 , -7.9) | Not transmitted | (-0.8 , 0.5) |
| | Color tone | Light grey | Light purple | Not transmitted | Colorless |
| Visible light transmittance | | 71.8% | 63.7% | Not transmitted | 89.9% |
| Change in visible light transmittance by antibacterial metal | | -18.3% | -26.4% | Not transmitted | -0.2% |
| Antibacterial property ($\Delta$Log) | | LEVEL 3 ($\Delta$LOG > 4.0) | LEVEL 3 ($\Delta$LOG > 4.0) | LEVEL 1 ($\Delta$LOG = 1.4) | LEVEL 3 ($\Delta$LOG > 4.0) |
| Antibacterial property after wiping with damp cloth ($\Delta$Log) | | LEVEL 3 ($\Delta$LOG > 4.0) | LEVEL 3 ($\Delta$LOG > 4.0) | LEVEL 1 ($\Delta$LOG =0.6) | × ($\Delta$LOG = - 0.1) |

## Table 2-1

| | | Example 1 | Example 2 | Example 3 | Example 4 | Example 5 |
|---|---|---|---|---|---|---|
| Substrate main body | Type | Soda lime glass | Soda lime glass | Soda lime glass | Soda lime glass | Soda lime glass |
| | Thickness | 3mm | 3mm | 3mm | 3mm | 3mm |
| Base layer | Silicon oxide film thickness | | | | 10nm | 5nm |
| Antibacterial metal islands | Antibacterial metal type | Ag | Ag | Ag | Ag | Ag |
| | Target film thickness for antibacterial metal film formation | 1nm | 3nm | 0.5nm | 1nm | 1nm |
| | Average contact angle | 55° | 60° | 45° | 50° | 50° |
| | Average diameter | 25 nm | 60 nm | 20nm | 30nm | 30nm |
| | Surface density | 80 pieces／$\mu m^2$ | 30 pieces／$\mu m^2$ | 75 pieces／$\mu m^2$ | 85 pieces／$\mu m^2$ | 85 pieces／$\mu m^2$ |
| | Average height | 10nm | 35nm | 8nm | 8nm | 9nm |
| Surface resistance | | $>9.1\times10^7\Omega/\square$ | $>9.1\times10^7\Omega/\square$ | $>9.1\times10^7\Omega/\square$ | $>9.1\times10^7\Omega/\square$ | $>9.1\times10^7\Omega/\square$ |
| Transmitted color tone | (a*,b*) | (-0.7 , 0.5) | (1.0 , 0) | (-0.7 , 0.4) | (-0.7 , 0.3) | (-0.6 , 0.4) |
| | Color tone | Colorless | Colorless | Colorless | Colorless | Colorless |
| Visible light transmittance | | 89.9% | 82.8 | 90.0% | 89.5% | 89.7% |
| Change in visible light transmittance by antibacterial metal | | -0.2% | -7.3% | -0.1% | -0.4% | -0.3% |
| Antibacterial property ($\Delta$Log) | | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) |
| Antibacterial property after wiping with damp cloth ($\Delta$Log) | | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) |

Table 2-2

| | | Example 6 | Example 7 | Example 8 | Example 9 | Example 10 |
|---|---|---|---|---|---|---|
| Substrate main body | Type | Soda lime glass | Soda lime glass | Soda lime glass | Soda lime glass | Soda lime glass |
| | Thickness | 3mm | 3mm | 3mm | 3mm | 3mm |
| Base layer | Silicon oxide film thickness | | | | 10nm | |
| Antibacterial metal islands | Antibacterial metal type | Cu | Cu | Cu | Cu | Zn |
| | Target film thickness for antibacterial metal film formation | 1nm | 3nm | 0.5nm | 1nm | 1nm |
| | Average contact angle | 30° | 35° | 30° | 30° | 40° |
| | Average diameter | 15 nm | 30nm | 10nm | 15nm | 20nm |
| | Surface density | 120 pieces/$\mu m^2$ | 80 pieces/$\mu m^2$ | 95 pieces/$\mu m^2$ | 115 pieces/$\mu m^2$ | 95 pieces/$\mu m^2$ |
| | Average height | 5nm | 10nm | 5nm | 5nm | 8nm |
| Surface resistance | | $>9.1\times10^7\,\Omega/\square$ | $>9.1\times10^7\,\Omega/\square$ | $>9.1\times10^7\,\Omega/\square$ | $>9.1\times10^7\,\Omega/\square$ | $>9.1\times10^7\,\Omega/\square$ |
| Transmitted color tone | $(a*,b*)$ | (-0.9 , 0.7) | (-1.2 , 2.1) | (-0.9 , 0.6) | (-0.9 , 1.0) | (-0.9 , 0.6) |
| | Color tone | Colorless | Colorless | Colorless | Colorless | Colorless |
| Visible light transmittance | | 89.3% | 80.9% | 89.5% | 89.2% | 88.7% |
| Change in visible light transmittance by antibacterial metal | | -0.8% | -9.2% | -0.6% | -0.7% | -1.4% |
| Antibacterial property ($\Delta Log$) | | LEVEL 3 ($\Delta LOG>4.0$) | LEVEL 3 ($\Delta LOG>4.0$) | LEVEL 3 ($\Delta LOG>4.0$) | LEVEL 3 ($\Delta LOG>4.0$) | LEVEL 1 ($\Delta LOG=0.6$) |
| Antibacterial property after wiping with damp cloth ($\Delta Log$) | | LEVEL 3 ($\Delta LOG>4.0$) | LEVEL 3 ($\Delta LOG>4.0$) | LEVEL 3 ($\Delta LOG>4.0$) | LEVEL 3 ($\Delta LOG>4.0$) | LEVEL 1 ($\Delta LOG>0.3$) |

## Table 2-3

| | | Example 11 | Example 12 | Example 13 | Example 14 | Example 15 |
|---|---|---|---|---|---|---|
| Substrate main body | Type | Soda lime glass | Soda lime glass | Soda lime glass | Soda lime glass | Soda lime glass |
| | Thickness | 3mm | 3mm | 3mm | 3mm | 3mm |
| Base layer | Silicon oxide film thickness | | | | | |
| Antibacterial metal islands | Antibacterial metal type | Ag+Pd (Pd:1.0 mass%) | Ag+Pd (Pd:1.0 mass%) | Ag+Pd (Pd:1.0 mass%) | Ag+Pd (Pd:15 mass%) | Ag+Pd (Pd:15 mass%) |
| | Target film thickness for antibacterial metal film formation | 1nm | 3nm | 0.5nm | 1nm | 3nm |
| | Average contact angle | 60° | 70° | 50° | 70° | 75° |
| | Average diameter | 30nm | 55 nm | 40 nm | 40 nm | 85 nm |
| | Surface density | 75 pieces／μm² | 55 pieces／μm² | 70 pieces／μm² | 70 pieces／μm² | 45 pieces／μm² |
| | Average height | 20nm | 25nm | 15nm | 15nm | 35nm |
| Surface resistance | | $>9.1\times10^7\,\Omega/\square$ | $>9.1\times10^7\,\Omega/\square$ | $>9.1\times10^7\,\Omega/\square$ | $>9.1\times10^7\,\Omega/\square$ | $>9.1\times10^7\,\Omega/\square$ |
| Transmitted color tone | (a*,b*) | (-0.8 , 0.5) | (1.3 , 0.1) | (-0.8 , 0.5) | (-0.8 , 0.5) | (-0.8 , 1.7) |
| | Color tone | Colorless | Colorless | Colorless | Colorless | Colorless |
| Visible light transmittance | | 89.8% | 82.4% | 89.1% | 90.0% | 89.8% |
| Change in visible light transmittance by antibacterial metal | | -0.3% | -7.7% | -1.0% | -0.1% | -0.3% |
| Antibacterial property (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |

EP 2 088 131 A1

In Examples 1 to 19 and Comparative Examples 3 to 7, antibacterial metal islands were formed using an in-line sputtering system SCH-3030 manufactured by ULVAC Inc. Targets of 5 inches × 20 inches were used. The distance between the substrate and the target was about 65 mm. In order to reduce the film growth rate, shielding plates were

Table 2-4

| | | Example 16 | Example 17 | Example 18 | Example 19 |
|---|---|---|---|---|---|
| Substrate main body | Type | Soda lime glass | Soda lime glass | Soda lime glass | Soda lime glass |
| | Thickness | 3mm | 3mm | 3mm | 3mm |
| Base layer | Silicon oxide film thickness | | | | |
| Antibacterial metal islands | Antibacterial metal type | Ag+Pd (Pd:15 mass%) | Ag+Pd+Cu (Pd:0.9 mass% Cu:0.6 mass%) | Ag+Pd+Cu (Pd:0.9 mass% Cu:0.6 mass%) | Ag+Pd+Cu (Pd:0.9 mass% Cu:0.6 mass%) |
| | Target film thickness for antibacterial metal film formation | 0.5nm | 1nm | 3nm | 0.5nm |
| | Average contact angle | 55° | 40° | 50° | 35° |
| | Average diameter | 25nm | 20 nm | 35 nm | 20nm |
| | Surface density | 55 pieces╱μm² | 115 pieces╱μm² | 90 pieces╱μm² | 90 pieces╱μm² |
| | Average height | 10nm | 8nm | 20nm | 7nm |
| Surface resistance | | $>9.1×10^7\Omega/\square$ | $>9.1×10^7\Omega/\square$ | $>9.1×10^7\Omega/\square$ | $>9.1×10^7\Omega/\square$ |
| Transmitted color tone | (a*,b*) | (-0.8 , 0.5) | (-0.8 , 0.6) | (-0.5 , -2.6) | (-0.8 , 0.5) |
| | Color tone | Colorless | Colorless | Colorless | Colorless |
| Visible light transmittance | | 90.0% | 89.1% | -80.9% | 89.6% |
| Change in visible light transmittance by antibacterial metal | | -0.1% | -1.0% | -9.2% | -0.5% |
| Antibacterial property (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) |

placed between the substrate and the target as shown in FIG. 5, and 50 mm away from the substrate. As shown in FIG. 5, a long and narrow slit extending in a direction parallel to the longitudinal direction of the target and in a direction perpendicular to the carrying direction of the substrate was formed by the shielding plates. The width of the slit was 5 mm. The substrate was not subjected to heating during the film formation.

The detailed sputtering conditions for forming the antibacterial metal island were as follows:

*Target: Ag, Cu, Zn, Ag + Pd (Pd: 1.0 mass%),
Ag + Pd (Pd: 15.0 mass%),
or Ag + Pd + Cu (Pd: 0.9 mass%, Cu: 0.6 mass%)
*Gas pressure: 10 mTorr
*Inert gas type: Ar 100%
*Input power: DC 0.3 kW (0.62 W/cm$^2$)
*Moving speed $\fallingdotseq$ 1000 mm/min (finely adjusted according to the film growth rate for the target)

The delivery pipes of argon gas were provided in such a manner that the gas is discharged into the space formed by the shielding plates and the target, as shown in FIG. 5.

In Comparative Example 2, Example 4, Example 5, and Example 9, the silicon oxide films as base layers were formed by a sputtering method using an in-line sputtering system MLH-6215 manufactured by ULVAC Inc. Specifically, silicon targets of 5 inches $\times$ 15 inches doped with phosphorous for imparting conductivity thereto were used so as to form the silicon oxide films by a reactive sputtering method in an oxygen gas atmosphere. The substrates were not subjected to heating during the film formation. The distance between the substrate and the target was about 60 mm. The other detailed sputtering conditions for forming the silicon oxide films were as follows.

Sputtering conditions for forming silicon oxide ($SiO_2$) films

*Target: Si (P-doped)
*Gas pressure: 3 mTorr
*Gas ratio: oxygen ($O_2$) 80% + argon (Ar) 20%
*Input power: DC pulse 2.0 kW (power density: 4.13 W/cm$^2$)

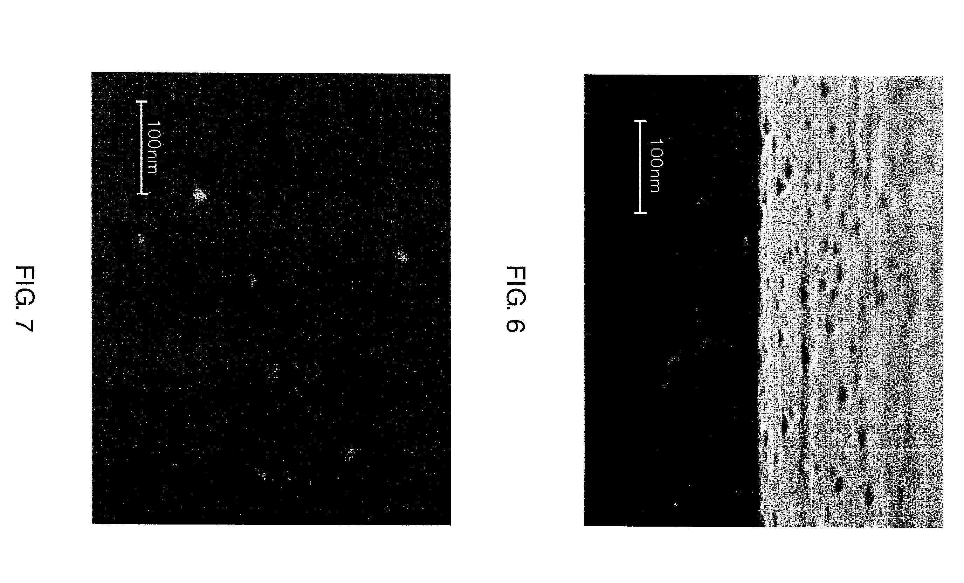

FIG. 6 shows a cross-sectional SEM image of Example 1 on which antibacterial metal islands are formed as described above. The cross-sectional SEM image was taken by a
field-emission scanning electron microscope S-4700 manufactured by Hitachi, Ltd. The SEM image was taken at an accelerating voltage of 5 kV with a magnification of 100,000 at an inclination angle of 10 degrees with respect to the cross section. Based on this cross-sectional SEM image, the contact angles between the substrate and the respective antibacterial metal islands, the heights of the antibacterial metal islands, and the heights thereof were measured.
The average value of the contact angles was 90 degrees or less. The average diameter of the antibacterial metal islands was about 25 nm, and they were dispersed relatively uniformly across the surface.

As is obvious from the results of Examples, the average contact angle between the substrate and the antibacterial metal islands may be 60 degrees or less in the antibacterial substrate of the present invention. For example, the average contact angle of 60 degrees or less can be obtained by depositing the antibacterial metal with a target film thickness, as mentioned above, of about 1 nm. In the case where the contact angle is small, a substance is less likely to be snagged on the antibacterial metal islands when it comes into contact with them, and the abrasion resistance is improved, which is desirable.

Next, FIG. 7 shows a reflection electron image of the surface of Example 1. Spots in the image are antibacterial metal islands. Based on this reflection electron image, the surface density of the antibacterial metal islands was measured. The surface density of the antibacterial metal islands was about 80 pieces/$\mu$m$^2$. It was also confirmed that contrast (light and dark) spots were not observed in the reflection electron image of the surface of a substrate on which an antibacterial metal was not deposited.

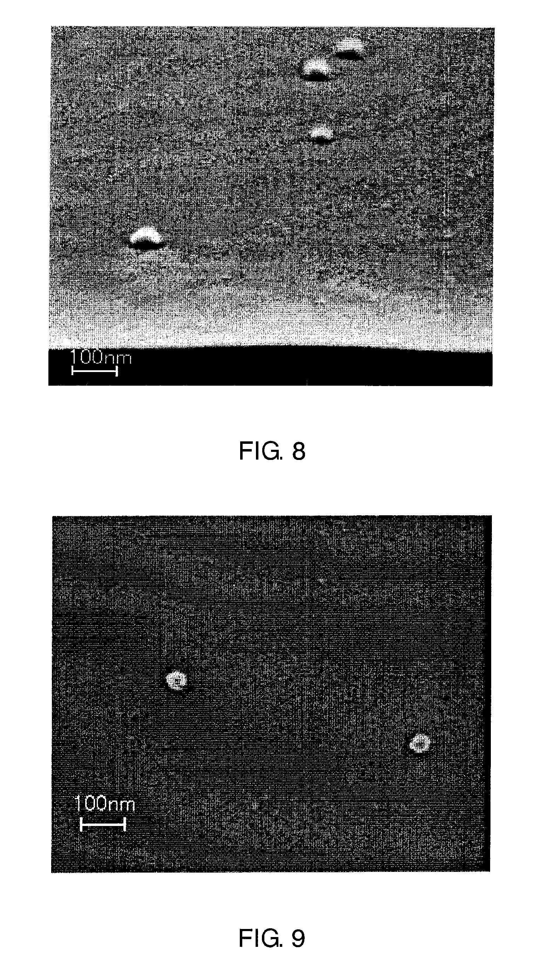

Likewise, FIG. 8 shows a cross-sectional SEM image of Comparative Example 9. The cross-sectional SEM image was taken by a field-emission scanning electron microscope S-4000 manufactured by Hitachi, Ltd. The SEM image was taken at an accelerating voltage of 15 kV with a magnification of 50,000 at an inclination angle of 10 degrees with respect to the cross section. The average contact angle between the substrate and the antibacterial metal particles was larger than 90 degrees. This is because Ag fine particles (antibacterial metal particles) derived from a dispersion liquid of Ag fine particles were deposited. The average diameter of the antibacterial metal particles was about 60 nm. When a dispersion liquid of Ag fine particles is used, it is difficult to disperse such excessively small Ag fine particles stably. FIG. 9 shows a secondary electron image of the surface of Comparative Example 9 taken at an accelerating voltage of 15 kV. The surface density of the antibacterial metal particles was about 3 pieces/$\mu$m$^2$.

The average contact angle of the antibacterial metal islands was calculated in the following manner. Ten antibacterial metal islands were selected from the cross-sectional SEM image, and the contact angles of these antibacterial metal islands were measured. Thus, the average value of the contact angles thus measured was obtained.

The average diameter of the antibacterial metal islands was calculated in the following manner. 10 antibacterial metal islands was selected from the cross-sectional SEM image, and the diameters of these antibacterial metal islands were measured. Thus, the average value of the diameters thus measured was obtained.

The surface density of the antibacterial metal islands was calculated by measuring the number of the antibacterial metal islands observed in an area of 500 nm $\times$ 500 nm on the reflection electron image of the surface.

The antibacterial property of each sample was evaluated in the following procedure.

As test bacteria, Staphylococcus aureus was used. First, the test bacteria was cultivated in a culture medium (Nutrient Agar manufactured by Difco) at 37°C for 18 hours. Growing colonies of the test bacteria were suspended in a culture medium (ordinary bouillon medium manufactured by Eiken Chemical Co., Ltd.), and the suspension thereof was adjusted to about $10^6$ CFU/mL. Next, 0.1 mL of the test bacteria suspension was dropped onto a sample of 5 cm $\times$ 5 cm. Next, a polypropylene film of 4 cm $\times$ 4 cm was placed on the sample. The resulting sample was placed in a moisturized petri dish, and let to act in a dark place for 24 hours under the conditions of a temperature of 25°C $\pm$ 5°C and a humidity of 95%. After the 24-hour action, the sample was put into a sterile bag for stomacher, and a culture medium (SCDLP bouillon manufactured by Daigo) was added so as to wash away the bacteria. The culture medium was collected from the sterile bag, and the collected culture medium was used as an undiluted specimen. 1 mL of the undiluted specimen and serial 10-fold dilutions of the specimen (10-fold dilution, 100-fold dilution, 1000-fold dilution ... obtained by dilution with physiological saline) were respectively put into petri dishes, into which a culture medium (Nutrient Agar) was added to cultivate the bacteria. After the petri dishes were left at 37°C for 48 hours, the respective numbers of developed colonies in the dishes were measured. Based on the numbers of developed colonies, the antibacterial activity values were calculated by the following formulas:

$$\Delta \text{Log} = [\log(A/B)]$$

$\Delta$Log: antibacterial activity value (amount of change in the viable cell count)

A: average viable cell count (pieces) immediately after inoculation on a non-antibacterially treated test piece

B: average viable cell count (pieces) of an antibacterially treated test piece after 24-hour action thereof

For easy comparison, the antibacterial activity value $\Delta$Log of each sample was ranked in the following four levels so as to determine the relative merits between them.

$$\times : \quad \Delta \text{Log} < 0$$

LEVEL 1: $0 \leq \Delta\text{Log} < 2$

LEVEL 2: $2 \leq \Delta\text{Log} < 4$

LEVEL 3: $4 \leq \Delta\text{Log}$ (99.99% or more died)

It should be noted that the dark place used for the evaluation of the antibacterial property and the evaluation of the antifungal property to be described later is a place with an ultraviolet intensity of 0.001 mW/cm$^2$ or less.

The antibacterial property after wiping with a cloth was evaluated in the following procedure.

A terry cloth towel (new) for ordinary household use was wetted thoroughly with pure water, and the surface of each sample was wiped 200 times in the same direction. After that, the sample was rinsed with running pure water, and the antibacterial property thereof in the dark place was evaluated.

The transmitted color tone (a*, b*) of each sample was calculated, based on the transmission spectrum measured with a Perkin-Elmer Lambda 20-type spectrophotometer, in accordance with "Color specification - CIELAB and CIELUV color spaces" specified in Japanese Industrial Standard (JIS)-Z-8729. The transmission spectrum was measured using a standard illuminant $D_{65}$.

The visible light transmittance of each sample was calculated, based on the transmission spectrum measured with the Perkin-Elmer Lambda 20-type spectrophotometer, in accordance with "Testing method on transmittance, reflectance and emittance of flat glassses and evaluation of solar heat gain coefficient" specified in Japanese Industrial Standard (JIS)-R-3106. It should be noted that the transmission spectrum was obtained by focusing beam light that has entered and exited the sample, with a convex lens placed 60 mm away from the sample.

The sheet resistance (surface resistance) of each sample was measured, immediately after the formation of the antibacterial metal islands, using a resistance meter Loresta IP MCP-T250 manufactured by Mitsubishi Petrochemical Co., Ltd. (currently Mitsubishi Chemical Corporation). Specifically, the sheet resistance of each sample of 100 mm × 100 mm was measured by bringing 4-point probes of the resistance meter into contact with the center of the sample. It should be noted that the surface resistance can be measured using other test methods. For example, the surface resistance may be calculated based on the specific resistance measured by a Hall measurement apparatus.

The evaluation results shown in Tables 1-1 to 2-4 revealed the following.

In all Examples, an excellent antibacterial effect was confirmed in the dark place. This fact indicates that the antibacterial metal islands exhibited the antibacterial effect. In contrast, in Comparative Examples 1 and 2 on which antibacterial metal islands were not formed, the antibacterial effect was not exhibited. Comparative Example 8 in which the antibacterial metal is dispersed in the glaze had a weak antibacterial property.

Furthermore, in all Examples in which the average contact angles of the antibacterial metal islands were 90 degrees or less, high antibacterial properties were maintained even after they were wiped with the cloth. That is, a sufficient amount of antibacterial metal islands remained even after being wiped with the cloth. In contrast, in Comparative Example 9 in which the average contact angle of the antibacterial metal islands was larger than 90 degrees, no antibacterial property was exhibited after it was wiped with the cloth. That is, the antibacterial metal islands were wiped away by the cloth.

All Examples had surface resistances higher than $9.1 \times 10^7 \Omega/\square$ and extremely low conductivities, although highly conductive silver or copper was deposited on their surfaces.
This suggests that the antibacterial metal islands were formed on the substrates in a discontinuous manner.

All Examples had 15% or less visible light transmittance differences ΔT before and after the formation of the antibacterial metal islands. In contrast, Comparative Examples 3 to 7, in which the antibacterial metal was deposited in an amount sufficient to form a film, had 15% or more visible light transmittance differences ΔT before and after the formation of the film. In addition, significant changes in a* and b* values were observed, which means a considerable deterioration in the appearance thereof.

Next, Table 3 shows the antifungal properties in a dark place of Examples 1, 11, 14, and 17 (in which the main component of the antibacterial metal islands is silver), and Comparative Example 1.

Table 3

| | | Example 1 | Example 11 | Example 14 | Example 17 | Comparative Example 1 |
|---|---|---|---|---|---|---|
| Substrate main body | | Soda lime glass | Soda lime glass | Soda lime glass | Soda lime glass | Soda lime glass |
| Base layer | Silicon oxide film thickness | | | | | |
| Antibacterial metal islands | Antibacterial metal type | Ag | Ag+Pd (Pd:1.0 mass%) | Ag+Pd (Pd:15 mass%) | Ag+Pd+Cu (Pd:0.9 mass% Cu:0.6 mass%) | |
| | Target film thickness for antibacterial metal film formation | 1nm | 1nm | 1nm | 1nm | |
| Antifungal property (ΔLog) | | LEVEL 3 (ΔLOG > 3.0) | LEVEL 3 (ΔLOG > 3.0) | LEVEL 3 (ΔLOG > 3.0) | LEVEL 3 (ΔLOG > 3.0) | × (ΔLOG = 0.1) |

The antifungal property of each sample was evaluated in the following procedure.

As test bacteria, Penicillium funiculosum was used. First, the test bacteria was cultivated in a culture medium (Potato Dextrose Agar manufactured by Difco) at 25°C for 2 weeks. Growing colonies of the test bacteria were suspended in a culture medium (0.005% aerosol), and the suspension thereof was adjusted to about $10^5$ CFU/mL. Next, 0.1 mL of the test bacteria suspension was dropped onto a sample of 5 cm $\times$ 5 cm. Next, a polypropylene film of 4 cm $\times$ 4 cm was placed on the sample. The resulting sample was placed in a moisturized petri dish, and let to act in a dark place for 24 hours under the conditions of a temperature of 25°C $\pm$ 5°C and a humidity of 95%. After the 24-hour action, the sample was put into a sterile bag for stomacher, and a culture medium (0.005% aerosol) was added so as to wash away the bacteria. The culture medium was collected from the sterile bag, and the collected culture medium was used as an undiluted specimen. 1 mL of the undiluted specimen and serial 10-fold dilutions of the specimen (10-fold dilution, 100-fold dilution, 1000-fold dilution ... obtained by dilution with physiological saline) were respectively put into petri dishes, into which a culture medium (Potato Dextrose Agar) was added so as to cultivate the bacteria. After the petri dishes were left at 25°C for 1 week, the respective numbers of developed colonies in the dishes were measured. Based on the numbers of developed colonies, the antifungal activity values were calculated by the following formulas:

$$\Delta\text{Log} = [\log(A/B)]$$

$\Delta$Log: antifungal activity value (amount of change in the viable fungi count)
A: average viable fungi count (pieces) immediately after inoculation on a non-antibacterially treated test piece
B: average viable fungi count (pieces) of an antibacterially treated test piece after 24-hour action thereof

For easy comparison, the antifungal activity value $\Delta$Log of each sample was ranked in the following four levels so as to determine the relative merits between them.

$$\times: \quad \Delta\text{Log} < 1$$

LEVEL 1: $1 \leq \Delta$Log < 2
LEVEL 2: $2 \leq \Delta$Log < 3
LEVEL 3: $3 \leq \Delta$Log (99.9% or more died)

As shown in Table 3, in Comparative Example 1 in which the antibacterial metal islands were not formed, no antifungal property was observed. In contrast, in Examples 1, 11, 14, and 17, in which the antibacterial metal islands were formed, high antifungal properties were observed.

(Examples 20 to 39 and Comparative Examples 10 to 16)

Next, Examples and Comparative Examples in which photocatalyst layers are formed will be described. Tables 4-1 to 5-4 show the details of Examples and Comparative Examples. It should be noted that since the antibacterial metal islands are affected strongly by the photocatalyst layer, the morphology (shape, number and size) of the antibacterial metal islands varies significantly depending on the type of the photocatalyst layer and the presence or absence of the photocatalyst layer even if the same conditions for forming the antibacterial metal islands by a sputtering method are applied. Furthermore, there is a difference in the morphology of the antibacterial metal islands between the photocatalyst layer formed by the sputtering method and that formed by the thermal CVD method, even if the types of these photocatalyst layers are identical.

## Table 4-1

| | | Comparative Example 10 | Comparative Example 11 | Comparative Example 12 | Comparative Example 13 |
|---|---|---|---|---|---|
| Substrate main body | Type | Soda lime glass | Soda lime glass | Soda lime glass | Soda lime glass |
| | Thickness | 3mm | 3mm | 3mm | 4mm |
| Base layer | Silicon oxide film thickness | | 10nm | 5nm | 20nm |
| Photocatalyst layer | Zirconium oxide film thickness | | 10nm | 50nm | - |
| | Titanium oxide film thickness | | 5nm | 50nm | 30nm |
| | Photocatalyst layer formation method | | Sputtering | Sputtering | Thermal CVD |
| Antibacterial metal islands | Antibacterial metal type | | | | |
| | Target film thickness for antibacterial metal film formation | | | | |
| | Average contact angle | | | | |
| | Average diameter | | | | |
| | Surface density | | | | |
| | Average height | | | | |
| Surface resistance | | $>9.1\times10^7\Omega/\square$ | $>9.1\times10^7\Omega/\square$ | $>9.1\times10^7\Omega/\square$ | $>9.1\times10^7\Omega/\square$ |
| Transmitted color tone | (a*,b*) | (-0.8 , 0.4) | (-1.4 , 1.3) | (-0.7 , -5.7) | (-1.4 , 3.7) |
| | Color tone | Colorless | Colorless | Light blue | Colorless |
| Visible light transmittance | | 89.9% | 86.3% | 78.6% | 84.0% |
| Change in visible light transmittance by antibacterial metal | | | | | |
| Photo-oxidative degradation activity (ppm/min) | | 0 | 0.16 | 0.68 | 2.07 |
| Antibacterial property ($\Delta$Log) | Under irradiation of UV_0.01mW/cm$^2$ | × ($\Delta$LOG = - 0.5) | LEVEL 1 ($\Delta$LOG = 0.3) | LEVEL 3 ($\Delta$LOG > 4.0) | LEVEL 3 ($\Delta$LOG > 4.0) |
| | In dark place | × ($\Delta$LOG = - 0.8) | × ($\Delta$LOG = - 0.5) | × ($\Delta$LOG = - 0.4) | × ($\Delta$LOG = - 0.2) |
| Antibacterial property after wiping with damp cloth in dark place ($\Delta$Log) | | × ($\Delta$LOG = - 0.7) | × ($\Delta$LOG = - 0.7) | × ($\Delta$LOG = - 0.7) | × ($\Delta$LOG = - 0.7) |

Table 4-2

| | | Comparative Example 14 | Comparative Example 15 | Comparative Example 16 |
|---|---|---|---|---|
| Substrate main body | Type | Soda lime glass | Soda lime glass | Soda lime glass |
| | Thickness | 3mm | 3mm | 3mm |
| Base layer | Silicon oxide film thickness | 5nm | 5nm | 10nm |
| Photocatalyst layer | Zirconium oxide film thickness | 50nm | 50nm | 10nm |
| | Titanium oxide film thickness | 50nm | 50nm | 5nm |
| | Photocatalyst layer formation method | Sputtering | Sputtering | Sputtering |
| Antibacterial metal islands | Antibacterial metal type | Ag | Cu | Ag fine particles dispersion applied |
| | Target film thickness for antibacterial metal film formation | 10nm | 10nm | |
| | Average contact angle | Film | Film | 110° |
| | Average diameter | Film | Film | 50nm |
| | Surface density | Film | Film | 4 pieces/$\mu m^2$ |
| | Average height | Film | Film | 35nm |
| Surface resistance | | $8.9\times10^6 \Omega/\square$ | $6.5\times10^6 \Omega/\square$ | $>9.1\times10^7 \Omega/\square$ |
| Transmitted color tone | (a*,b*) | (-0.9, 1.9) | (-4.4, 1.7) | (-1.4, 1.4) |
| | Color tone | Light gray | Light gray | Colorless |
| Visible light transmittance | | 63.0% | 68.2% | 85.3% |
| Change in visible light transmittance by antibacterial metal | | -15.6% | -10.4% | -1.0% |
| Photo-oxidative degradation activity (ppm/min) | | 0 | 0 | 0.05 |
| Antibacterial property (ΔLog) | Under irradiation of UV_0.01mW/$cm^2$ | LEVEL 3 (ΔLOG > 4.0) | LEVEL 3 (ΔLOG > 4.0) | LEVEL 3 (ΔLOG > 4.0) |
| | In dark place | LEVEL 3 (ΔLOG > 4.0) | LEVEL 3 (ΔLOG > 4.0) | LEVEL 3 (ΔLOG > 4.0) |
| Antibacterial property after wiping with damp cloth in dark place (ΔLog) | | LEVEL 3 (ΔLOG > 4.0) | LEVEL 3 (ΔLOG > 4.0) | × (ΔLOG = - 0.2) |

## Table 5-1

| | | Example 20 | Example 21 | Example 22 | Example 23 | Example 24 |
|---|---|---|---|---|---|---|
| Substrate main body | Type | Soda lime glass | Soda lime glass | Soda lime glass | Soda lime glass | Soda lime glass |
| | Thickness | 3mm | 3mm | 4mm | 3mm | 3mm |
| Base layer | Silicon oxide film thickness | 10nm | 5nm | 20nm | 10nm | 10nm |
| Photocatalyst layer | Zirconium oxide film thickness | 10nm | 50nm | - | 10nm | 10nm |
| | Titanium oxide film thickness | 5nm | 50nm | 30nm | 5nm | 5nm |
| | Photocatalyst layer formation method | Sputtering | Sputtering | Thermal CVD | Sputtering | Sputtering |
| Antibacterial metal islands | Antibacterial metal type | Ag | Ag | Ag | Ag+Pd (Pd:1.0mass %) | Ag+Pd (Pd:15mass %) |
| | Target film thickness for antibacterial metal film formation | 1nm | 1nm | 1nm | 1nm | 1nm |
| | Average contact angle | 25° | 20° | 40° | 35° | 45° |
| | Average diameter | 20nm | 15nm | 110nm | 25nm | 30nm |
| | Surface density | 850 pieces／$\mu m^2$ | 950 pieces／$\mu m^2$ | 25 pieces／$\mu m^2$ | 850 pieces／$\mu m^2$ | 550 pieces／$\mu m^2$ |
| | Average height | 8nm | 6nm | 40nm | 10nm | 10nm |
| Surface resistance | | $>9.1\times10^7\Omega/\square$ | $>9.1\times10^7\Omega/\square$ | $>9.1\times10^7\Omega/\square$ | $>9.1\times10^7\Omega/\square$ | $>9.1\times10^7\Omega/\square$ |
| Transmitted color tone | (a*,b*) | (-1.4 , 1.7) | (-0.6 , -5.7) | (-1.5 , 3.3) | (-1.4 , 1.7) | (-1.4 , 1.6) |
| | Color tone | Colorless | Light blue | Colorless | Colorless | Colorless |
| Visible light transmittance | | 84.8% | 78.1% | 82.4% | 85.4% | 85.7% |
| Change in visible light transmittance by antibacterial metal | | -1.5% | -0.5% | -1.6% | -0.9% | -0.6% |
| Photo-oxidative degradation activity (ppm/min) | | 0.06 | 0.67 | 1.73 | 0.06 | 0.06 |
| Antibacterial property (ΔLog) | Under irradiation of UV_0.01mW/cm$^2$ | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| | In dark place | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |

## Table 5-2

| | | Example 25 | Example 26 | Example 27 | Example 28 | Example 29 |
|---|---|---|---|---|---|---|
| Substrate main body | Type | Soda lime glass | Soda lime glass | Soda lime glass | Soda lime glass | Soda lime glass |
| | Thickness | 3mm | 3mm | 3mm | 3mm | 3mm |
| Base layer | Silicon oxide film thickness | 10nm | 10nm | 5nm | 5nm | 5nm |
| Photocatalyst layer | Zirconium oxide film thickness | 10nm | 10nm | 50nm | 50nm | 50nm |
| | Titanium oxide film thickness | 5nm | 5nm | 50nm | 50nm | 50nm |
| | Photocatalyst layer formation method | Sputtering | Sputtering | Sputtering | Sputtering | Sputtering |
| Antibacterial metal islands | Antibacterial metal type | Ag+Pd+Cu (Pd:0.9 mass% Cu:0.6 mass%) | Cu | Ag | Ag | Ag+Pd (Pd:1.0 mass%) |
| | Target film thickness for antibacterial metal film formation | 1nm | 1nm | 3nm | 0.5nm | 1nm |
| | Average contact angle | 30° | 20° | 30° | 20° | 25° |
| | Average diameter | 15nm | 15nm | 25nm | 10nm | 20nm |
| | Surface density | 950 pieces／μm$^2$ | 1050 pieces／μm$^2$ | 1000 pieces／μm$^2$ | 900 pieces／μm$^2$ | 550 pieces／μm$^2$ |
| | Average height | 6nm | 5nm | 10nm | 6nm | 8nm |
| Surface resistance | | $>9.1×10^7 \Omega/\square$ | $>9.1×10^7 \Omega/\square$ | $>9.1×10^7 \Omega/\square$ | $>9.1×10^7 \Omega/\square$ | $>9.1×10^7 \Omega/\square$ |
| Transmitted color tone | (a*,b*) | (-1.1 , 0.3) | (-1.5 , 2.3) | (0.5 , -6.3) | (-0.6 , -5.7) | (-0.9 , -5.9) |
| | Color tone | Colorless | Colorless | Light blue | Light blue | Light blue |
| Visible light transmittance | | 83.5% | 85.0% | 70.6% | 78.3% | 77.7% |
| Change in visible light transmittance by antibacterial metal | | -2.8% | -1.3% | -8.0% | -0.3% | -0.9% |
| Photo-oxidative degradation activity(ppm/min) | | 0.08 | 0.06 | 0.73 | 0.68 | 0.58 |
| Antibacterial property(ΔLog) | Under irradiation of UV_0.01mW/cm$^2$ | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| | In dark place | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |

Table 5-3

| | | Example 30 | Example 31 | Example 32 | Example 33 | Example 34 |
|---|---|---|---|---|---|---|
| Substrate main body | Type | Soda lime glass | Soda lime glass | Soda lime glass | Soda lime glass | Soda lime glass |
| | Thickness | 3mm | 3mm | 3mm | 3mm | 3mm |
| Base layer | Silicon oxide film thickness | 5nm | 5nm | 5nm | 5nm | 5nm |
| Photocatalyst layer | Zirconium oxide film thickness | 50nm | 50nm | 50nm | 50nm | 50nm |
| | Titanium oxide film thickness | 50nm | 50nm | 50nm | 50nm | 50nm |
| | Photocatalyst layer formation method | Sputtering | Sputtering | Sputtering | Sputtering | Sputtering |
| Antibacterial metal islands | Antibacterial metal type | Ag+Pd (Pd:1.0 mass%) | Ag+Pd (Pd:15 mass%) | Ag+Pd (Pd:15 mass%) | Ag+Pd+Cu (Pd:0.9 mass% Cu:0.6 mass%) | Ag+Pd+Cu (Pd:0.9 mass% Cu:0.6 mass%) |
| | Target film thickness for antibacterial metal film formation | 3nm | 1nm | 3nm | 1nm | 3nm |
| | Average contact angle | 40° | 50° | 70° | 20° | 30° |
| | Average diameter | 55nm | 25nm | 65nm | 15nm | 35nm |
| | Surface density | 250 pieces／μm$^2$ | 650 pieces／μm$^2$ | 150 pieces／μm$^2$ | 1100 pieces／μm$^2$ | 550 pieces／μm$^2$ |
| | Average height | 20nm | 10nm | 25nm | 7nm | 13nm |
| Surface resistance | | >9.1×10$^7$Ω/□ | >9.1×10$^7$Ω/□ | >9.1×10$^7$Ω/□ | >9.1×10$^7$Ω/□ | >9.1×10$^7$Ω/□ |
| Transmitted color tone | (a*,b*) | (-1.5 , -6.6) | (-0.8 , -5.8) | (-1.3 , -6.3) | (-0.8 , -6.0) | (-1.3 , -7.1) |
| | Color tone | Light blue | Light blue | Light blue | Light blue | Light blue |
| Visible light transmittance | | 71.1% | 78.3% | 73.2% | 77.1% | 77.7% |
| Change in visible light transmittance by antibacterial metal | | -7.5% | -0.3% | -5.4% | -1.5% | -0.9% |
| Photo-oxidative degradation activity (ppm/min) | | 0.58 | 0.55 | 0.56 | 0.74 | 0.58 |
| Antibacterial property (ΔLog) | Under irradiation of UV_0.01mW/cm$^2$ | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| | In dark place | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |

Table 5-4

| | | Example 35 | Example 36 | Example 37 | Example 38 | Example 39 |
|---|---|---|---|---|---|---|
| Substrate main body | Type | Soda lime glass | Soda lime glass | Soda lime glass | Soda lime glass | Soda lime glass |
| | Thickness | 3mm | 3mm | 4mm | 4mm | 4mm |
| Base layer | Silicon oxide film thickness | 5nm | 5nm | 20nm | 20nm | 20nm |
| Photocatalyst layer | Zirconium oxide film thickness | 50nm | 50nm | - | - | - |
| | Titanium oxide film thickness | 50nm | 50nm | 30nm | 30nm | 30nm |
| | Photocatalyst layer formation method | Sputtering | Sputtering | Thermal CVD | Thermal CVD | Thermal CVD |
| Antibacterial metal islands | Antibacterial metal type | Cu | Zn | Ag+Pd (Pd:1.0 mass%) | Ag+Pd (Pd:15 mass%) | Ag+Pd+Cu (Pd:0.9 mass% Cu:0.6 mass%) |
| | Target film thickness for antibacterial metal film formation | 1nm | 1nm | 1nm | 1nm | 1nm |
| | Average contact angle | 15° | 20° | 55° | 65° | 50° |
| | Average diameter | 15nm | 15nm | 110nm | 120nm | 95nm |
| | Surface density | 1200 pieces／μm$^2$ | 850 pieces／μm$^2$ | 20 pieces／μm$^2$ | 15 pieces／μm$^2$ | 45 pieces／μm$^2$ |
| | Average height | 5nm | 5nm | 45nm | 50nm | 35nm |
| Surface resistance | | >9.1×10$^7$Ω/□ | >9.1×10$^7$Ω/□ | >9.1×10$^7$Ω/□ | >9.1×10$^7$Ω/□ | >9.1×10$^7$Ω/□ |
| Transmitted color tone | (a*,b*) | (-0.5 , -6.0) | (-0.6 , -5.9) | (-1.4 , 3.5) | (-0.8 , 3.5) | (-1.8 , 2.9) |
| | Color tone | Light blue | Light blue | Colorless | Colorless | Colorless |
| Visible light transmittance | | 76.6% | 76.9% | 82.2% | 82.6% | 81.6% |
| Change in visible light transmittance by antibacterial metal | | -2.0% | -1.7% | -1.8% | -1.4% | -2.4% |
| Photo-oxidative degradation activity (ppm/min) | | 0.59 | 0.67 | 2.00 | 1.95 | 2.10 |
| Antibacterial property (ΔLog) | Under irradiation of UV_0.01mW/cm$^2$ | LEVEL 3 (ΔLOG > 4.0) | LEVEL 3 (ΔLOG > 4.0) | LEVEL 3 (ΔLOG > 4.0) | LEVEL 3 (ΔLOG > 4.0) | LEVEL 3 (ΔLOG > 4.0) |
| | In dark place | LEVEL 3 (ΔLOG > 4.0) | LEVEL 1 (ΔLOG = 0.6) | LEVEL 3 (ΔLOG > 4.0) | LEVEL 3 (ΔLOG > 4.0) | LEVEL 3 (ΔLOG > 4.0) |
| Antibacterial property after wiping with damp cloth (ΔLog) | | LEVEL 3 (ΔLOG > 4.0) | LEVEL 1 (ΔLOG = 0.2) | LEVEL 3 (ΔLOG > 4.0) | LEVEL 3 (ΔLOG > 4.0) | LEVEL 3 (ΔLOG > 4.0) |

The conditions for forming the antibacterial metal islands and the silicon oxide film by a sputtering method are the same as described above.

In Examples 20, 21, and 23 to 36, and Comparative Examples 11, 12, 14, and 18, the photocatalyst layers were formed by the sputtering method using the in-line sputtering system MLH-6215 manufactured by ULVAC Inc. Metal

23

targets of 5 inches $\times$ 15 inches were used to form the photocatalyst layers by a reactive sputtering method in an oxygen gas atmosphere. The substrates were not subjected to heating during the film formation. The distance between the substrate and the target was about 60 mm. The other detailed sputtering conditions for forming the photocatalyst layers were as follows.

Sputtering conditions for forming titanium oxide ($TiO_2$) films

* Target: Titanium (Ti)
* Gas pressure: 20 mTorr
* Gas ratio: Oxygen ($O_2$) 100%
* Input power: DC 3.0 kW (power density: 6.40 W/cm$^2$) Sputtering conditions for forming zirconium oxide ($ZrO_2$) films
* Target: Zirconium (Zr)
* Gas pressure: 10 mTorr
* Gas ratio: Oxygen ($O_2$) 100%
* Input power: DC 2.6 kW (power density: 5.54 W/cm$^2$)

In Examples 22, and 37 to 39, and Comparative Example 13, each of the photocatalyst layers was formed by an in-bath CVD method, in which a glass ribbon was used as a substrate main body and a titanium oxide thin film was formed on the surface of the substrate. The specific film formation method is as follows.

Molten glass was obtained by melting glass in a float furnace, and the molten glass with its temperature controlled at 1150°C to 1100°C was allowed to flow into a float bath. The molten glass was formed into a glass ribbon while being cooled in the float bath. The molten glass was formed into a glass ribbon with a thickness of 4.0 mm. On this glass ribbon, a silicon oxide film with a thickness of 20 nm was formed as a base layer. After that, in the float bath, a titanium oxide thin film was formed by blowing a source gas thereon. As the source gas, a gas obtained by diluting titanium tetrachloride ($TiCl_4$) and ethyl acetate ($C_4H_8O_2$) with a nitrogen gas to a predetermined concentration was used. The titanium oxide film with a thickness of 30 nm was formed by adjusting the concentration of the source gas and the carrying speed of the glass ribbon.

Comparative Example 16 was obtained by forming a photocatalyst layer consisting of a zirconium oxide film and a titanium oxide film under the same sputtering conditions as in Examples 20, and 23 to 26, and subsequently spraying a commercially available alcohol dispersion liquid of Ag fine particles onto the surface of the photocatalyst layer and drying it at room temperature.

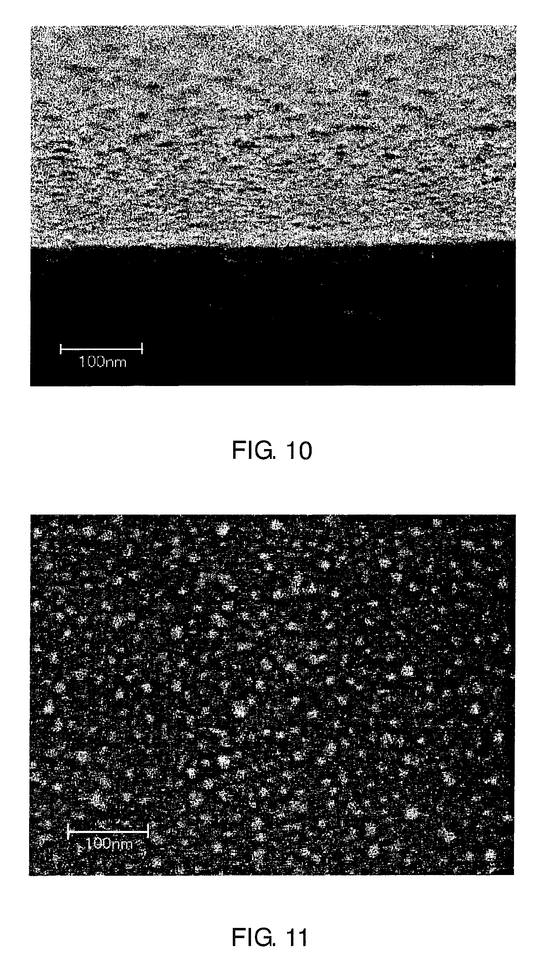

FIG. 10 shows a cross-sectional SEM image of Example 20 on which antibacterial metal islands are formed as described above. The cross-sectional SEM image was taken by the field-emission scanning electron microscope S-4700 manufactured by Hitachi, Ltd. The SEM image was taken at an accelerating voltage of 5 kV with a magnification of 100,000 at an inclination angle of 10 degrees with respect to the cross section. The average of contact angles between the respective antibacterial metal islands and the substrate was 90 degrees or less. The average diameter of the antibacterial metal islands was about 20 nm.

FIG. 11 shows a reflection electron image of the surface of Example 20 taken at an accelerating voltage of 1 kV. In FIG. 11, spots in the image are antibacterial metal islands. Based on this reflection electron image, the surface density of the antibacterial metal islands was measured. The surface density of the antibacterial metal islands was about 850 pieces/$\mu$m2.

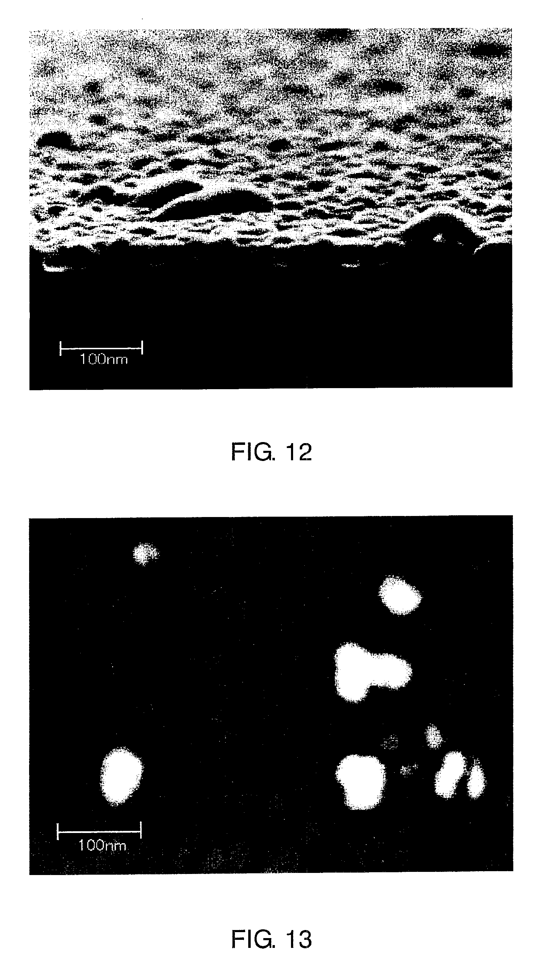

FIG. 12 and FIG. 13 show a cross-sectional SEM image and a reflection electron image of Example 22 respectively taken under the same conditions as in Example 20. The average of contact angles between the respective antibacterial metal islands and the substrate was 90 degrees or less. The average diameter of the antibacterial metal islands was about 110 nm.

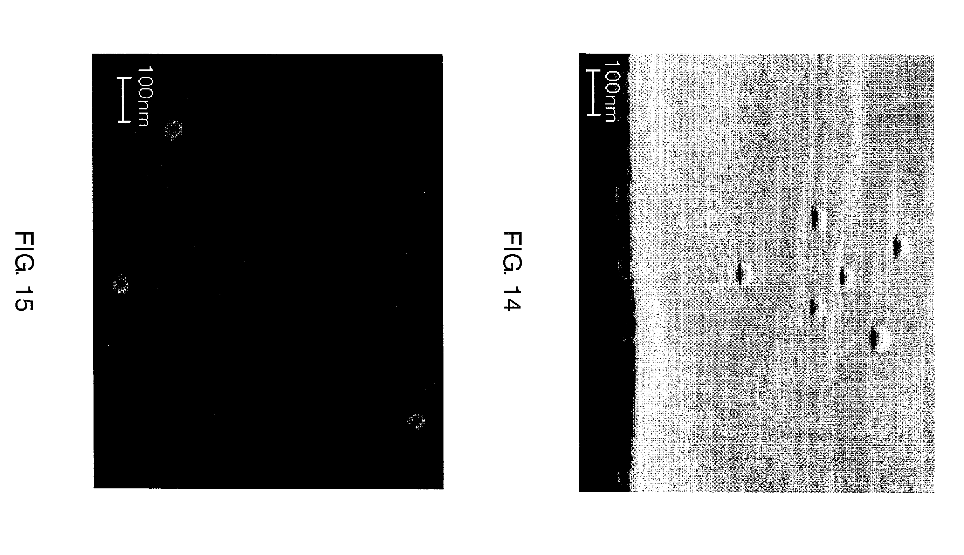

Likewise, FIG. 14 shows a cross-sectional SEM image of Comparative Example 16. The cross-sectional SEM image was taken by the field-emission scanning electron microscope S-4000 manufactured by Hitachi, Ltd. The SEM image was taken at an accelerating voltage of 15 kV with a magnification of 50,000 at an inclination angle of 10 degrees with respect to the cross section. The average contact angle between the substrate and the antibacterial metal particles was larger than 90 degrees. The average diameter of the antibacterial metal particles was about 50 nm. FIG. 15 shows a secondary electron image of the surface of Comparative Example 16 taken at an accelerating voltage of 15 kV. The surface density of the antibacterial metal particles of Comparative Example 16 was about 4 pieces/$\mu$m$^2$.

The photo-oxidative degradation activity was evaluated in the following procedure.

A sample was irradiated with ultraviolet rays at an intensity of 1.0 mW/cm$^2$ for 1 hour and put into a Tedlar bag. Then, a slit of the bag was closed with a polypropylene adhesive tape (manufactured by 3M Corporation). After that, a liter of synthetic air was injected into the Tedlar bag, and then 95 mL of 1 vol% acetaldehyde gas was injected with a gas-tight syringe. Thus, acetaldehyde gas diluted to 90 to 100 ppm was prepared in the Tedlar bag. After the acetaldehyde gas was injected as mentioned above, the Tedlar bag was left standing while intercepting the light incident into the Tedlar bag for 60 minutes, so that the adsorption reached an equilibrium state. 60 minutes later, the initial acetaldehyde concentration was measured, and irradiation of ultraviolet rays at an intensity of 1.0 mW/cm$^2$ was started. Thereafter, the acetaldehyde gas concentration was measured after a lapse of 30 minutes, 60 minutes, 120 minutes, and 300 minutes. Thus, the photo-oxidative degradation activity was evaluated based on the rate of change in the acetaldehyde gas concentration within a range where it decreased linearly.

The antibacterial property, antibacterial property after wiping with a cloth, transmitted color tone, and visible light transmittance were evaluated in the same manner as described above.

The evaluation results shown in Tables 4-1 to 5-4 revealed the following.

In all Examples, an excellent antibacterial effect was confirmed both under the irradiation of ultraviolet rays at an intensity of 0.01 mW/cm$^2$ and in the dark place. This fact indicates that the antibacterial metal islands exhibited the antibacterial effect. In contrast, in Comparative Example 10, the antibacterial effect was not exhibited either under the irradiation of ultraviolet rays or in the dark place. In Comparative Examples 11 to 13, the antibacterial effect did not manifest itself in the dark place.

Furthermore, in all Examples in which the average contact angles of the antibacterial metal islands were 90 degrees or less, high antibacterial properties were maintained even after they were wiped with the cloth. That is, a sufficient amount of antibacterial metal islands remained even after being wiped with the cloth. In contrast, in Comparative Example 16 in which the average contact angle of the antibacterial metal islands was larger than 90 degrees, no antibacterial property was exhibited after it was wiped with the cloth. That is, the antibacterial metal islands were wiped away by the cloth.

All Examples maintained the photo-oxidative degradation properties even after the antibacterial metal islands were formed. This suggests that since the antibacterial metal islands are formed in a discontinuous manner, the titanium oxide surface is exposed to outside, which results in exhibiting the photocatalytic effect. In contrast, Comparative Example 10, in which the photocatalyst layer was not formed, did not exhibit the photo-oxidative degradation property. In Comparative Examples 14 and 15, since the amount of the antibacterial metal was excessively large, the antibacterial metal was not deposited in the form of islands but covered the photocatalyst layer almost entirely. As a result, the photo-oxidative degradation property was not exhibited.

All Examples had surface resistances higher than $9.1 \times 10^7$ Ω/□ and extremely low conductivities, although highly conductive silver or copper was deposited on their surfaces.

This suggests that the antibacterial metal islands were formed on the titanium oxide films in a discontinuous manner.

All Examples had 15% or less visible light transmittance differences ΔT before and after the formation of the antibacterial metal islands. In contrast, Comparative Example 14, in which the antibacterial metal was deposited in an amount sufficient to form a film, had 15% or more visible light transmittance differences ΔT before and after the formation of the film. In addition, significant changes in a* and b* values were observed, which means a considerable deterioration in the appearance thereof.

Next, Table 6-1 and 6-2 show the antifungal properties in a dark place of Examples 20, and 22 to 25 (in which the main component of the antibacterial metal islands is silver), and Comparative Examples 10, 11, and 13. The antifungal properties were evaluated in the same manner as described above.

Table 6-1

| | | Example 20 | Example 22 | Example 23 | Example 24 | Example 25 |
|---|---|---|---|---|---|---|
| Substrate main body | Type | Soda lime glass | Soda lime glass | Soda lime glass | Soda lime glass | Soda lime glass |
| | Thickness | 3mm | 4mm | 3mm | 3mm | 3mm |
| Base layer | Silicon oxide film thickness | 10nm | 20nm | 10nm | 10nm | 10nm |
| Photocatalyst layer | zirconium oxide film thickness | 10nm | - | 10nm | 10nm | 10nm |
| | Titanium oxide film thickness | 5nm | 30nm | 5nm | 5nm | 5nm |
| | Photocatalyst layer formation method | Sputtering | Thermal CVD | Sputtering | Sputtering | Sputtering |

(continued)

| | | Example 20 | Example 22 | Example 23 | Example 24 | Example 25 |
|---|---|---|---|---|---|---|
| Antibacterial metal islands | Antibacterial metal type | Ag | Ag | Ag+Pd (pd: 1.0 mass%) | Ag+Pd (Pd: 15 mass%) | Ag+pd+Cu (Pd:0.9 mas% Cu: 0.6 mass%) |
| | Target film thickness for antibacterial metal film formation | 1nm | 1nm | 1nm | 1nm | 1nm |
| Photo-oxidative degradation activity(ppm/min) | | 0.06 | 1.73 | 0.06 | 0.06 | 0.08 |
| Antifungal property (ΔLog) | Under irradiation ofUV0.1mW/cm$^2$ | LEVEL 2 (ΔLOG = 2.4) | LEVEL 1 (ΔLOG = 1.3) | LEVEL 2 (ΔLOG = 2.5) | LEVEL 2 (ΔLOG = 2.8) | LEVEL 2 (ΔLOG = 2.5) |
| | In dark place | LEVEL 3 (ΔLOG > 3.0) | LEVEL 3 (ΔLOG > 3.0) | LEVEL 3 (ΔLOG > 3.0) | LEVEL 3 (ΔLOG > 3.0) | LEVEL 3 (ΔLOG > 3.0) |

Table 6-2

| | | Comparative Example 10 | Comparative Example 11 | Comparative Example 13 |
|---|---|---|---|---|
| Substrate main body | Type | Soda lime glass | Soda lime glass | Soda lime glass |
| | Thickness | 3mm | 3mm | 4mm |
| Base layer | Silicon oxide film thickness | | 10nm | 20nm |
| Photocatalyst layer | Zirconium oxide film thickness | | 10nm | - |
| | Titanium oxide film thickness | | 5nm | 30nm |
| | Photocatalyst layer formation method | | Sputtering | Thermal CVD |
| Antibacterial metal islands | Antibacterial metal type | | | |
| | Target film thickness for antibacterial metal film formation | | | |
| Photo-oxidative degradation activity (ppm/min) | | 0 | 0.16 | 2.07 |
| Antifungal property (ΔLog) | Under irradiation of UV_0.1mW/cm² | × (ΔLOG = 0.1) | × (ΔLOG = 0.9) | × (ΔLOG = 0.4) |
| | In dark place | × (ΔLOG = 0) | × (ΔLOG = 0.8) | × (ΔLOG = 0.3) |

As shown in Tables 6-1 and 6-2, Comparative Examples 10, 11, and 13, in which antibacterial metal islands were not formed, exhibited no antifungal property. In contrast, all of Examples 20, and 22 to 25, in which antibacterial metal islands were formed, had high antifungal properties both in the dark place and under the irradiation of ultraviolet rays at an intensity of 0.1 mW/cm².

(Examples 40 to 43 and Comparative Examples 17 to 20)

Next, Examples and Comparative Examples using figured glass sheets will be described. The figured glass sheets used in Examples and Comparative Examples are translucent glass sheets having an irregular surface opposite to the other surface on which an antibacterial metal is to be deposited. These figured glass sheets are commonly used as architectural glass sheets. Furthermore, figured glass sheets used in Examples 42 and 43 and Comparative Examples 19 and 20 are glass sheets tempered by a thermal treatment. Specifically, these figured glass sheets were obtained by heating figured glass sheets in a heating furnace at 700°C for 3 minutes and then quenching the heated glass sheets by air. As the base layers, tin oxide films were used.

The tin oxide films were formed by the sputtering method using the in-line sputtering system MLH-6215 manufactured by ULUAC Inc. A tin metal target of 5 inches $\times$ 15 inches was used to form each of the tin oxide films by a reactive sputtering method in an oxygen gas atmosphere. The substrate was not subjected to heating during the film formation. The distance between the substrate and the target was about 60 mm. The other detailed sputtering conditions for forming the tin oxide films were as follows.

Sputtering conditions for forming tin oxide ($SnO_2$) films

* Target: Sn
* Gas pressure: 10 mTorr
* Gas ratio: Oxygen ($O_2$) 100%
* Input power: DC 2.0 kW (power density: 4.13 W/cm$^2$)

Tables 7 and 8 show the details of Examples and Comparative Examples and the evaluation results of various characteristics thereof. It should be noted that the transmittance of a figured glass sheet varies depending on the measurement conditions due to the light scattering effect, but in the present description, the visible light transmittance and transmitted color tone are the values obtained by the measurement methods as described above. Furthermore, the conditions of the thermal treatment for tempering glass may be the commonly used tempering conditions, or may be so-called semi-tempering conditions.

## Table 7

| | | Example 40 | Example 41 | Example 42 | Example 43 |
|---|---|---|---|---|---|
| Substrate main body | Type | Soda lime glass (figured glass sheet) | Soda lime glass (figured glass sheet) | Soda lime glass (tempered figured glass sheet) | Soda lime glass (tempered figured glass sheet) |
| | Thickness | 4mm | 4mm | 4mm | 4mm |
| Base layer | Tin oxide film thickness | | 10nm | | 10nm |
| Antibacterial metal islands | Antibacterial metal type | Ag | Ag | Ag | Ag |
| | Target film thickness for antibacterial metal film formation | 1nm | 1nm | 1nm | 1nm |
| | Average contact angle | 55° | 30° | 50° | 25° |
| | Average diameter | 25 nm | 20nm | 25 nm | 20nm |
| | Surface density | 80 pieces $\diagup$ $\mu m^2$ | 460 pieces $\diagup$ $\mu m^2$ | 80 pieces $\diagup$ $\mu m^2$ | 560 pieces $\diagup$ $\mu m^2$ |
| | Average height | 12nm | 9nm | 12nm | 8nm |
| Transmitted color tone | $(a^*, b^*)$ | (-0.4 , 0.7) | (-1.0, 1.7) | (-0.4 , 0.6) | (-0.9, 1.7) |
| | Color tone | Colorless | Colorless | Colorless | Colorless |
| Visible light transmittance | | 43.0% | 41.5% | 42.8% | 41.1% |
| Change in visible light transmittance by antibacterial metal | | -0.3% | -0.9% | -0.3% | -1.0% |
| Antibacterial property ($\Delta$Log) | Under irradiation of UV_0.01mW/cm² | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) |
| | In dark place | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) |
| Antibacterial property after wiping with damp cloth in dark place ($\Delta$Log) | | LEVEL 3 ($\Delta$LOG > 4.0) | LEVEL 3 ($\Delta$LOG > 4.0) | LEVEL 3 ($\Delta$LOG > 4.0) | LEVEL 3 ($\Delta$LOG > 4.0) |

## Table 8

| | | Comparative Example 17 | Comparative Example 18 | Comparative Example 19 | Comparative Example 20 |
|---|---|---|---|---|---|
| Substrate main body | Type | Soda lime glass (figured glass sheet) | Soda lime glass (figured glass sheet) | Soda lime glass (tempered figured glass sheet) | Soda lime glass (tempered figured glass sheet) |
| | Thickness | 4mm | 4mm | 4mm | 4mm |
| Base layer | Tin oxide film thickness | | 10nm | | 10nm |
| Antibacterial metal islands | Antibacterial metal type | | | | |
| | Target film thickness for antibacterial metal film formation | | | | |
| | Average contact angle | | | | |
| | Average diameter | | | | |
| | Surface density | | | | |
| | Average height | | | | |
| Transmitted color tone | (a*,b*) | (-0.5 , 0.5) | (-1.0, 1.4) | (-0.4 , 0.5) | (-0.9, 1.3) |
| | Color tone | Colorless | Colorless | Colorless | Colorless |
| Visible light transmittance | | 43.3% | 42.4% | 43.1% | 42.1% |
| Change in visible light transmittance by antibacterial metal | | | | | |
| Antibacterial property (ΔLog) | Under irradiation of UV_0.01mW/cm$^2$ | × (ΔLOG = - 0.4) | × (ΔLOG = - 0.7) | × (ΔLOG = - 0.3) | × (ΔLOG = - 0.5) |
| | In dark place | × (ΔLOG = - 0.6) | × (ΔLOG = - 0.4) | × (ΔLOG = - 0.6) | × (ΔLOG = - 0.7) |
| Antibacterial property after wiping with damp cloth in dark place (ΔLog) | | × (ΔLOG = - 0.5) | × (ΔLOG = - 0.6) | × (ΔLOG = - 0.8) | × (ΔLOG = - 0.5) |

The figured glass sheet of Comparative Example 17 had a low visible light transmittance of about 43%. In Examples 40 to 43, reductions in visible light transmittances were small, and sufficient and sustainable antibacterial properties were obtained. There was little change in the color tones.

According to the present invention, by forming fine antibacterial metal islands on a substrate while controlling the amount thereof, as described above, it is possible to provide an antibacterial substrate exhibiting an excellent antibacterial effect with its transparency being not impaired.

**Industrial Applicability**

The antibacterial substrate of the present invention is applicable to any article that is likely to be exposed to bacteria and fungi such as molds as well as microbes such as viruses. Specifically, the antibacterial substrate of the present invention is applicable to architectural window glass, partition glass, door glass, automotive glass, display glass, mirrors, transparent substrates for DNA analysis, solar cells, personal digital assistants, sanitary goods, medical supplies, electronic devices, optical components, glass products for biochemical experiments, medical test chips, and medical endoscopes and optical fibers for medial operations. The antibacterial substrate of the present invention using a tempered or semi-tempered figured glass sheet is suitable particularly for bathroom doors and bathroom windows.

The antibacterial substrate of the present invention can be used to suppress the growth of bacteria and molds in hospitals, nursing facilities, homes, and other places. Therefore, health and hygiene problems caused by bacteria and molds are expected to decrease.

**Claims**

1. An antibacterial substrate comprising:

   a substrate; and
   a plurality of antibacterial metal islands formed on a surface of the substrate,

   wherein the antibacterial metal islands are exposed to an external atmosphere, and an average value of contact angles between the substrate and the respective antibacterial metal islands is 90 degrees or less, as measured on the basis of results of surface observation with a scanning electron microscope.

2. The antibacterial substrate according to Claim 1, wherein an average value of diameters of the antibacterial metal islands is in a range of 5 to 500 nm.

3. The antibacterial substrate according to Claim 1, wherein an average value of diameters of the antibacterial metal islands is in a range of 5 to 50 nm.

4. The antibacterial substrate according to Claim 1, wherein at least one of the antibacterial metal islands is present in an arbitrary region having an area of 1 $\mu$m $\times$ 1 $\mu$m on the surface of the substrate.

5. The antibacterial substrate according to Claim 1, wherein:

   the substrate has a light transmitting property; and
   a difference $\Delta T$ between a visible light transmittance of the antibacterial substrate and a visible light transmittance of the substrate without the antibacterial metal islands is 15% or less.

6. The antibacterial substrate according to Claim 1, wherein:

   the substrate has a light transmitting property; and
   a visible light transmittance of the antibacterial substrate is 30% or more.

7. The antibacterial substrate according to Claim 1, wherein a maximum value of heights of the antibacterial metal islands is 50 nm or less.

8. The antibacterial substrate according to Claim 1, wherein the antibacterial metal islands contain, as a main component metal, any one selected from the group consisting of silver, copper, and zinc.

9. The antibacterial substrate according to Claim 1, wherein the antibacterial metal islands contain a main component metal and an additive metal.

10. The antibacterial substrate according to Claim 9, wherein the main component metal is silver, and the additive metal is palladium.

11. The antibacterial substrate according to Claim 1, wherein the substrate has a photocatalyst layer containing titanium oxide, and the photocatalyst layer serves as the surface of the substrate.

12. The antibacterial substrate according to Claim 11, wherein:

the substrate further has, as a base layer of the photocatalyst layer, a film containing polycrystalline zirconium oxide having a monoclinic crystalline structure; and
the photocatalyst layer contains polycrystalline titanium oxide having an anatase crystalline structure.

13. The antibacterial substrate according to Claim 1, wherein the substrate has a substrate main body and a base layer formed in contact with the substrate main body.

14. The antibacterial substrate according to Claim 13, wherein the base layer contains at least one selected from the group consisting of silicon oxide, silicon nitride, tin oxide, and zinc-tin complex oxide.

15. The antibacterial substrate according to Claim 1, wherein the substrate is formed of one or more materials selected from the group consisting of a glass sheet, a plastic sheet, and a plastic film.

16. The antibacterial substrate according to Claim 1, wherein the substrate is formed of a tempered or semi-tempered figured glass sheet.

17. The antibacterial substrate according to Claim 1, wherein the substrate is formed of a mirror.

18. The antibacterial substrate according to Claim 1, wherein the antibacterial metal islands are formed by a sputtering method.

19. A method of manufacturing an antibacterial substrate, comprising a step of depositing an antibacterial metal in a form of islands, with a target film thickness of at least 0.1 nm but not more than 3 nm, on a surface of a substrate by a sputtering method carried out in an atmosphere of a gas containing an inert gas as a main component.

FIG. 1

FIG. 2

FIG. 3

## FIG. 4

## FIG. 5

FIG. 6

FIG. 7

FIG. 8

FIG. 9

FIG. 10

FIG. 11

FIG. 12

FIG. 13

FIG. 14

FIG. 15

## INTERNATIONAL SEARCH REPORT

| | International application No. |
| --- | --- |
| | PCT/JP2007/070202 |

A.  CLASSIFICATION OF SUBJECT MATTER
*C03C17/09*(2006.01)i, *A01N25/08*(2006.01)i, *A01N59/16*(2006.01)i, *A01N59/20* (2006.01)i, *A01P3/00*(2006.01)i, *B01J35/02*(2006.01)i, *B32B15/04*(2006.01)i, *B32B17/06*(2006.01)i, *C03C17/36*(2006.01)i, *C23C14/34*(2006.01)i
According to International Patent Classification (IPC) or to both national classification and IPC

B.  FIELDS SEARCHED

Minimum documentation searched (classification system followed by classification symbols)
C03C17/09, A01N25/08, A01N59/16, A01N59/20, A01P3/00, B01J35/02, B32B15/04, B32B17/06, C03C17/36, C23C14/34

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| Y | JP 2000-246115 A  (Akira FUJISHIMA), 12 September, 2000 (12.09.00), Claims 1 to 6; Par. Nos. [0001], [0004], [0014]; Figs. 1 to 3 (Family: none) | 1-19 |
| Y | JP 9-111380 A  (Nisshin Steel Co., Ltd.), 28 April, 1997 (28.04.97), Claims 1, 2; Par. No. [0010] (Family: none) | 1-19 |
| Y | JP 2006-152353 A  (Kobe Steel, Ltd.), 15 June, 2006 (15.06.06), Claims 1 to 3; Par. No. [0018] (Family: none) | 1-19 |

| ☒ | Further documents are listed in the continuation of Box C. | ☐ | See patent family annex. |
| --- | --- | --- | --- |

| | | |
| --- | --- | --- |
| * | Special categories of cited documents: | |
| "A" | document defining the general state of the art which is not considered   to be of particular relevance | "T"   later document published after the international filing date or priority date and not in conflict with the application but cited to understand the principle or theory underlying the invention |
| "E" | earlier application or patent but published on or after the international filing date | "X"   document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"   document of particular relevance; the claimed invention cannot be considered to involve an inventive step when the document is |
| "O" | document referring to an oral disclosure, use, exhibition or other means | combined with one or more other such documents, such combination being obvious to a person skilled in the art |
| "P" | document published prior to the international filing date but later than the priority date claimed | "&"   document member of the same patent family |

| Date of the actual completion of the international search | Date of mailing of the international search report |
| --- | --- |
| 08 November, 2007 (08.11.07) | 20 November, 2007 (20.11.07) |

| Name and mailing address of the ISA/ | Authorized officer |
| --- | --- |
| Japanese Patent Office | |
| Facsimile No. | Telephone No. |

Form PCT/ISA/210 (second sheet) (April 2007)

40

**EP 2 088 131 A1**

**INTERNATIONAL SEARCH REPORT**

| International application No. |
| --- |
| PCT/JP2007/070202 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2004-183030 A (Ryoko HATTORI), 02 July, 2004 (02.07.04), Claim 4 (Family: none) | 1-19 |
| Y | JP 10-97940 A (Hitachi Metals, Ltd.), 14 April, 1998 (14.04.98), Par. Nos. [0016], [0029] (Family: none) | 1-19 |
| Y | JP 2001-68702 A (Kaneka Corp.), 16 March, 2001 (16.03.01), Par. Nos. [0018], [0032] to [0034] (Family: none) | 1-19 |
| Y | WO 2004/108283 A1 (Nippon Sheet Glass Co., Ltd.), 16 December, 2004 (16.12.04), Claims 1, 2, 14, 16 & EP 1637225 A1 | 11-13 |
| Y | JP 8-109043 A (Nippon Soda Co., Ltd.), 30 April, 1996 (30.04.96), Par. No. [0013] (Family: none) | 13,14 |

Form PCT/ISA/210 (continuation of second sheet) (April 2007)

41

**EP 2 088 131 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004183030 A
- JP 9111380 A
- JP 2006152353 A
- JP 2000246115 A
- WO 2006064059 A1